(19) **Europäisches Patentamt European Patent Office Office européen des brevets**

(11) **EP 1 362 447 B1**

(12) **FASCICULE DE BREVET EUROPEEN**

(45) Date de publication et mention de la délivrance du brevet:
**11.04.2007 Bulletin 2007/15**

(51) Int Cl.:
*H04L 1/06* (2006.01)     *H03M 13/45* (2006.01)
*H03M 13/25* (2006.01)     *H03M 13/29* (2006.01)

(21) Numéro de dépôt: **02706856.8**

(22) Date de dépôt: **14.02.2002**

(86) Numéro de dépôt international:
**PCT/FR2002/000562**

(87) Numéro de publication internationale:
**WO 2002/067488 (29.08.2002 Gazette 2002/35)**

(54) **PROCEDE ET SYSTEME DE CODAGE-DECODAGE ITERATIF DE FLUX DE DONNEES NUMERIQUES CODEES PAR COMBINAISONS SPATIO-TEMPORELLES, EN EMISSION ET RECEPTION MULTIPLE**

VERFAHREN UND SYSTEM ZUM ITERATIVEN KODIEREN/DEKODIEREN EINES STROMS VON DURCH RAUMZEITKODIERTE KOMBINIERUNGEN DIGITALER DATEN, FÜR MEHRFACHES SENDEN UND EMPFANGEN

METHOD AND SYSTEM FOR THE ITERATIVE ENCODING-DECODING OF STREAMS OF DIGITAL DATA ENCODED BY SPATIO-TEMPORAL COMBINATIONS, IN MULTIPLE TRANSMISSION AND RECEPTION

(84) Etats contractants désignés:
**AT BE CH CY DE DK ES FI FR GB GR IE IT LI LU MC NL PT SE TR**

(30) Priorité: **21.02.2001 FR 0102343**

(43) Date de publication de la demande:
**19.11.2003 Bulletin 2003/47**

(73) Titulaire: **FRANCE TELECOM**
**75015 Paris (FR)**

(72) Inventeurs:
• **BERTHET, Antoine**
  **F-92290 Chatenay (FR)**
• **VISOZ, Raphael**
  **F-92130 Issy-les-Moulineaux (FR)**

(74) Mandataire: **Hassine, Albert**
**Cabinet Plasseraud**
**52 rue de la Victoire**
**75440 Paris Cedex 09 (FR)**

(56) Documents cités:
**US-A- 6 128 330**

• **BAUCH G: "CONCATENATION OF SPACE-TIME BLOCK CODES AND ''TURBO''-TCM" ICC '99. 1999 IEEE INTERNATIONAL CONFERENCE ON COMMUNICATIONS. CONFERENCE RECORD. VANCOUVER, CA, JUNE 6 - 10, 1999, IEEE INTERNATIONAL CONFERENCE ON COMMUNICATIONS, NEW YORK, NY: IEEE, US, vol. 2, 6 juin 1999 (1999-06-06), pages 1202-1206, XP000898047 ISBN: 0-7803-5285-8**
• **STEFANOV A ET AL: "TURBO CODED MODULATION FOR SYSTEMS WITH TRANSMIT AND RECEIVE ANTENNA DIVERSITY" 1999 IEEE GLOBAL TELECOMMUNICATIONS CONFERENCE. GLOBECOM'99. SEAMLESS INTERCONNECTION FOR UNIVERSAL SERVICES. RIO DE JANEIRO, BRAZIL, DEC. 5-9, 1999, IEEE GLOBAL TELECOMMUNICATIONS CONFERENCE, NEW YORK, NY: IEEE, US, vol. 5, 5 décembre 1999 (1999-12-05), pages 2336-2340, XP000958539 ISBN: 0-7803-5797-3**
• **BAUCH G ET AL-DAHIR N: "Iterative equalization and decoding with channel shortening filters for space-time coded modulation" VEHICULAR TECHNOLOGY CONFERENCE FALL 2000. IEEE VTS FALL VTC2000, vol. 4, 24 - 28 septembre 2000, pages 1575-1582, XP002180247 Boston, MA, USA**

- **LEUNG HANG CHING JASON: "Low complexity turbo space-time code for system with large number of antennas" PROCEEDINGS OF GLOBAL TELECOMMUNICATIONS CONFERENCE GLOBECOM '00, vol. 2, 27 novembre 2000 (2000-11-27) - 1 décembre 2000 (2000-12-01), pages 990-994, XP002180248 San Francisco, CA, USA**

**Description**

L'invention concerne, en général, les systèmes de transmission en radiofréquences à haut ou très haut débit, utilisables soit dans le cadre de la téléphonie mobile, soit dans le domaine également prometteur de la liaison radiofréquences entre appareils électroniques, en environnement quelconque.

Dans les domaines d'application précités, la transmission de données numériques à un haut degré de fiabilité et de sécurité se heurte à un obstacle majeur, celui de la transmission de ces données par l'intermédiaire d'un canal de transmission variable et dont les caractéristiques ne sont pas connues a priori. Les données numériques transmises sont subdivisées en symboles, constitués par des suites de bits de ces données, chaque symbole permettant la modulation d'une onde radioélectrique porteuse transmise sur le canal.

La très forte demande de processus de transmission fiable à haut débit en radiofréquence a provoqué le lancement et l'exécution de nombreux travaux de recherche relatifs à la définition et à la mise en oeuvre de systèmes de radiocommunication mobiles A.M.R.T. (Accès Multiple à Répartition dans le Temps) de future génération, encore désignés systèmes T.D.M.A. pour *Time Division Multiple Access* en langage anglo-saxon.

Les canaux de transmission en radiofréquences sont connus par le fait qu'il sont à la fois sélectifs en fréquence et variables dans le temps. La variation temporelle est consécutive à la mobilité ou à la vitesse du ou des utilisateurs. Leur sélectivité en fréquence résulte des conditions de propagation des signaux radiofréquence par trajets multiples et de la superposition destructive des signaux reçus, issus des propagations sur ces trajets différents. Le phénomène de sélectivité en fréquence provoque un phénomène d'interférence intersymboles, préjudiciable à la qualité de la transmission et de la détection de ces symboles à leur réception. Le phénomène d'interférence intersymboles et la complexité des récepteurs sont sensiblement accrus avec le débit de transmission.

Ces caractéristiques spécifiques des canaux de transmission en radiofréquences précédemment citées ont toujours conduit à la mise en oeuvre de systèmes d'interfaçage radiofréquences adaptés particulièrement délicate, ce d'autant plus lorsqu'une transmission à haut débit et à haute efficacité spectrale est recherchée.

Toutefois la sélectivité en fréquence et la variation temporelle précitées des canaux de transmission en radiofréquences, considérées à priori comme des obstacles majeurs, ont cependant pu faire l'objet jusqu'à ce jour d'investigations, par intermédiaire du concept de diversité, ainsi qu'il sera explicité ci-après.

Dans cet ordre d'idées, le concept de turbo-code présenté par C. BERROU, A. GLAVIEUX, P. THITIMAJSHIMA dans l'article intitulé *"Near Shannon limit error correcting coding and decoding : Turbo Codes",* IEEE ICC'93, pp1064-1070 Geneva, Switzerland, May 1993, a permis le regain d'intérêt des processus itératifs tant du point de vue théorique que du point de vue pratique.

Le succès remarquable d'un tel concept réside dans trois de ses aspects spécifiques : caractère quasi aléatoire, concaténation de plusieurs codes composés de faible complexité, et décodage itératif par entrée/sortie pondérée de chaque code constitutif, grâce à l'utilisation d'information disponible à partir de tous les autres codes.

Une généralisation de ces concepts a conduit à une nouvelle approche, désignée par le principe de turbo-détection, dans le domaine de la théorie de la communication, cette approche consistant en une actualisation récursive d'information aléatoire à posteriori sur des données ou des symboles parmi l'ensemble des fonctions concaténées dans la chaîne de réception.

Le processus de turbo-détection décrit dans l'article publié par C. DOUILLART, M. JEZECHIEL, C. BERROU, A. PICART, P. DIDIER, A. GLAVIEUX et intitulé "Interactive Correction of Intersymbol Interférence : Turbo-Equalization" publié dans *European Trans.* On *Telecommunication,* Vol. 6, pp. 507-511, Septembre 1995, apparaît comme une application pleine d'intérêt du concept de "principe turbo-détection", dans le but de réduire ou inhiber les phénomènes d'interférence intersymboles engendrés par un canal de transmission radiofréquences.

Grâce à une modélisation de la structure d'interférence intersymboles comme un code convolutionnel de rendement unité non systématique non récursif et variable dans le temps, la détection de données et le décodage (égalisation) du canal de transmission peuvent être identifiés formellement à une concaténation série de deux codes en treillis. Le décodage optimal à maximum de vraisemblance de l'ensemble ainsi formé, conditionné à la connaissance parfaite du canal de transmission, peut alors être atteint grâce à un processus itératif similaire à celui décrit par S. BENEDETTO, D. DIVSALAR, C. MONTORSI, F. POLLARA, dans l'article intitulé *"Serial Concatenation of Interleaved Codes: Performances Analysis, Design and Iterative Decoding"* et publié par TDA Progress Report 42-126, Août 1996.

Différents domaines présentant un intérêt sont apparus à la suite d'études antérieures relatives à la turbo-détection.

L'un de ces domaines concerne l'estimation d'un canal désadapté, telle que décrite dans l'article de G. BAUCH, V. FRANZ, intitulé *"A Comparizon of Soft-in Soft-out Algorithm for Turbo-Detection"* et publié par Proceedings of ICT, vol. 2, pp. 259-263, Portos Carras, Grèce, Juin 1998 et qui a été au moins partiellement résolue par la mise en oeuvre d'un récepteur "totalement turbo" développé par A.O. BERTHET, B. SAYRAC ÜNAL, R. VISOZ. Le concept de base consiste à superposer à l'architecture du turbo-détecteur un processus itératif de réestimation du canal, qui tire parti de l'information disponible sur les symboles après décodage de canal.

Un autre de ces domaines soumis à investigation consiste à renforcer le code interne relatif au phénomène d'interférence intersymboles par l'introduction d'une modulation codée en treillis (TCM), ainsi qu'il a été proposé par R. VISOZ, P. TORTELIER et A.O. BERTHET dans l'article intitulé "*Generalised Viterbi Algorithm for Trellis coded Signals transmitted through Broadband Wireless Channels*" publié par Electronic Letters, pp. 227 à 228, 3 Fev.2000, Vol. 36, No.3 et par A.O. BERTHET, R. VISOZ, B. ÜNAL et P. TORTELIER dans l'article intitulé *"A Comparison of Several Strategies for Iteratively Decoding Serially concatenated Convolutional Codes in Multipath Rayleigh Fading Environment"* et publié par Proc. IEEE GLOBECOM' 2000, San Francisco USA, Novembre 2000. Dans ce dernier article, un schéma de code TCM concaténé en série a révélé fournir au moins deux avantages selon lesquels :

1. le décodage peut débuter plus tôt, en comparaison au processus de turbo-détection classique, alors que la performance est asymptotiquement meilleure ;
2. la complexité calculatoire peut être réduite grâce à la réalisation d'une détection SISO des données et un décodage TCM conjoint sur le seul treillis TCM à états réduits.

Par nature, toutefois, le processus de turbo-détection exploite totalement la diversité introduite par le codage et l'entrelacement ,et, en conséquence, ses performances sont fortement liées à la profondeur d'entrelacement.

Si le processus se révèle efficace même vis-à-vis des pires configurations d'interférences intersymboles statiques, il ne peut être spécialement adapté à des profils radiofréquences spécifiques, confer ETSI.GSM Recommandations, 05.05 version 5.8.0 Décembre 1996, où la plupart des sorties du canal sont en général faciles à égaliser mais caractérisées par de profonds évanouissements de fréquence.

Lorsque la perturbation du canal de transmission engendrée par la variation de la distribution temporelle d'énergie supplante la dispersion sélective en fréquence, le processus de turbo-détection reste sans effet, en particulier dans le cas d'applications sensibles au retard. Confer l'article de M. PUKKILA "*Turbo Equalisation for the Enhanced GPRS System"* publié par Proc. IEEE conf.

PIMRCOO London UK, 2000. C'est la raison pour laquelle, dans le but d'assurer la performance la meilleure possible, les systèmes mobiles TDMA évolués doivent être conçus à la fois pour combattre le phénomène d'interférence intersymboles et pour recouvrir d'autres formes de diversité, c'est-à-dire la diversité spatiale d'antenne.

Pour bénéficier du phénomène de diversité spatiale, grâce aux techniques de codage spatio-temporel, ainsi que décrit par V. TAROCK, N. SESHADRI, A.R. CALDERBANK dans l'article intitulé *"Space Time Codes for High Data Rata Wireless Communication : Performance Criterion and Code Construction"* et publié par IEEE Trans. Inform. Theory. Vol. 44, n°2, March 1998, tout en mettant en oeuvre une turbo-détection, le modèle de communication de base proposé met en oeuvre un code externe, essentiel pour le processus de turbo-détection, entrelacé avec une modulation codée en treillis spatio-temporelle (ST-TCM).

En fait, un tel modèle doit être considéré comme une modulation codée en treillis spatio-temporelle concaténée en série. Il permet de maintenir l'avantage essentiel consistant à permettre une égalisation conjointe et un décodage spatio-temporel interne grâce à des algorithmes SISO sous-optimaux de complexité réduite, contrairement à l'approche plus complexe distincte, décrite par C. BAUCH, A. NAGUILS, N. SESHADRI dans l'article intitulé "PA Equalisation of *Space-Time* Coded *Signals over Frequency Selective Channels"* et publié par Proc. Wireless Communications on Networking Conference (WCNC) September 1999, approche selon laquelle la détection de données et le décodage spatio-temporel sont réalisés séparément de manière itérative.

Enfin, différents travaux ayant pour objet d'apporter une amélioration significative de l'efficacité spectrale des codes du type modulation codée en treillis spatio-temporelle concaténés en série, ci-après désignés codes ST-TCM concaténés en série, ont été publiés. On peut citer notamment G. BAUCH *"Concatenation of Space-Time Block Codes and "Turbo" -TCM""*, ICC'99, 1999 IEEE International Conference on Communications. Conference Record. Vancouver, CA, 6-10 juin 1999, IEEE International Conférence on Communications, New-York, NY: IEEE, US, vol.2, pages 1202-1206.

A la connaissance des inventeurs, il existe au plus quatre approches distinctes susceptibles de permettre une amélioration de l'efficacité spectrale des codes ST-TCM concaténés en série :

- Une première possibilité consiste à réduire au maximum le rendement ou taux de codage, tant du code interne que du code externe. Malheureusement, la réduction du débit de codage de ce code externe a pour conséquence des mauvaises performances de la turbo-détection.
- Une deuxième possibilité consiste à accroître l'ordre de modulation du code ST-TCM concaténé en série. Un tel accroissement, toutefois, au-delà d'un ordre 4, par la mise en oeuvre des meilleures configurations des codes ST-TCM les plus connus, tels que ceux décrits par V. TAROCK, N. SESHADRI, A.R. CALDERBANK dans l'article précédemment cité, a pour effet une très forte réduction des performances du code interne, lequel se ramène à une combinaison du code ST-TCM et du code de canal.
- En raison du fait, toutefois, que les schémas de code TCM concaténés en série consistant en de simples modulations QPSK codées par un code convolutif de rendement 1/2 se sont avérés très efficaces dans le cadre de nombreux environnements d'interférence intersymboles, ainsi que décrit par A.O. BERTHET, R. VISOZ, B. ÜNAL et P. TORTELIER dans l'article intitulé "*A comparison of Several Strategies for Iteratively Decoding Serially Concatenated Convolutional Codes in Multipath Rayleigh Fading Environment*" précédemment cité, la troisième possibilité consiste à multiplier les données numériques de plusieurs utilisateurs, ou de manière équivalente, différents flux de données distincts, dans le même intervalle de temps du système TDMA. Une telle approche permet d'augmenter l'efficacité spectrale globale du système. Dans le cadre de cette troisième possibilité, une première mise en oeuvre peut consister à modéliser une communication multi-utilisateurs en multiplexant plusieurs processus de codage ST-TCM concaténés en série totalement indépendants et en considérant chaque flux de données d'entrée distinct comme un utilisateur spécifique. Une telle mise en oeuvre n'exploite toutefois pas le phénomène de diversité spatiale.

- Une quatrième approche consiste enfin à démultiplexer un seul flux de données pré-encodées sur une pluralité d'antennes d'émission, conformément au processus BLAST (*Bell Labs Layered Space-Time*) tel que décrit par G.J. FOSHINI, G.D. GOLDEM, R.A. VALENZUELA, P.W. WOLANIANSKY, dans l'article intitulé *"Simplified processing for High Spectral Efficiency Wireless Communication Employing Multi-element Arrays"* publié par IEEE JSAC, Vol. 17, n˚11, pp. 1841-1852, novembre 1999.

Dans les deux dernières approches, l'interface radiofréquence ainsi décrite est en particulier basée sur l'utilisation de plusieurs antennes en émission et en réception et repose, pour atteindre de très hauts débits et une haute efficacité spectrale, sur l'émission en parallèle de plusieurs flux de données codés par un code spatio-temporel, code STC, correspondant sensiblement à un code ST-TCM.

En particulier, la technique permettant la mise en oeuvre de l'interface radiofréquences précitée présente l'inconvénient majeur de ne pas supporter l'interférence intersymboles, en raison de l'utilisation d'un récepteur linéaire sous optimal dont les performances sont donc, en l'absence de codage, directement liées au rang de la matrice de transfert représentative du canal de transmission, le phénomène de diversité spatiale à l'émission et à la réception était seul pris en compte.

En outre, du fait du seul traitement linéaire introduit, le nombre d'antennes en réception ne peut être inférieur au nombre d'antennes en émission, le nombre d'antennes en réception devant même être augmenté, vis-à-vis du nombre d'antennes en émission, afin de tenter d'améliorer les performances et le niveau de qualité de détection et de réception alors que le canal de transmission d'essai était un canal exempt d'interférences intersymboles. En conclusion, les performances d'une telle interface radiofréquences restent étroitement liées aux conditions de propagation existant sur le canal de transmission et une application directe d'une telle interface radiofréquences à la radiotéléphonie mobile ne peut être que difficilement envisagée, car les récepteurs de radiotéléphonie mobile, en raison de leur taille et de leur encombrement réduit, n'admettent guère un nombre d'antennes d'émission/ réception supérieur à deux.

La présente invention a pour objet de remédier à l'ensemble des inconvénients des différentes approches de mise en oeuvre d'interface radiofréquences de l'art antérieur, et, notamment, de s'affranchir tant des contraintes limitatrices du débit de transmission que des contraintes liées au nombre d'antennes respectif en émission et en réception, tout en prenant en compte le phénomène de diversité spatiale et/ou temporelle en émission et en réception.

En particulier, un objet de la présente invention est la mise en oeuvre d'un procédé et d'un système de codage, respectivement de décodage itératif de flux de données numériques codées par combinaisons spatio-temporelles, en présence d'interférence intersymboles, en émission et en réception multiple capable de permettre la transmission et le décodage de symboles en environnement quelconque, générateur de phénomène d'interférence intersymboles sévère.

Un autre objet de la présente invention est également la mise en oeuvre des procédés et des systèmes précités permettant, grâce à leurs performances remarquables de traitement du phénomène d'interférences intersymboles, d'atteindre des niveaux de débit très élevés susceptibles de faire face à la demande de l'ensemble des systèmes TDMA des générations futures.

Un autre objet de la présente invention est la mise en oeuvre des procédés et de systèmes précités, permettant la définition et la réalisation d'interfaces radiofréquences à haute efficacité spectrale et permettant d'atteindre de très hauts débits, malgré la présence du phénomène d'interférence intersymboles, ces interfaces de type universel pouvant être mises en oeuvre dans les applications les plus variées.

Un autre objet de la présente invention est, en conséquence, la mise en oeuvre d'une interface radiofréquences, mettant en oeuvre un processus de turbo-détection, dans lequel le code interne permettant d'égaliser le canal de transmission est renforcé par l'introduction d'une modulation codée en treillis, code TCM, le treillis du code interne résultant pouvant se ramener à une combinaison du code TCM et du canal de transmission, le processus d'égalisation et de décodage du treillis résultant, lorsque ce dernier est réduit, étant ramené à un processus d'égalisation et de décodage conjoint sous-optimal.

Un autre objet de la présente invention est, en conséquence, la mise en oeuvre d'une interface radiofréquences dans laquelle, d'une part, le processus de turbo-détection mis en oeuvre permet de traiter le phénomène d'interférence intersymboles engendré par l'effet de mémoire du canal de transmission, et, d'autre part, le phénomène d'évanouissement en fréquence lié à la variation de la distribution de l'énergie radiofréquence dans le canal de transmission est traité, grâce à la mise en oeuvre du phénomène de diversité spatiale en émission et en réception.

Un autre objet de la présente invention est, en outre, malgré le phénomène de diversité spatiale introduit, en particulier en émission, la mise en oeuvre d'une interface radiofréquences dans laquelle la complexité du récepteur constitutif de cette interface est réduite et où, en outre, le nombre d'antennes de réception est indépendant du nombre d'antennes d'émission.

Un autre objet de la présente invention est enfin la mise en oeuvre d'une interface radiofréquences dans laquelle, au niveau du récepteur, le processus de turbo-détection mis en oeuvre fait appel à l'algorithme de Viterbi généralisé à entrée/sortie souple, ce qui permet d'exécuter les opérations d'égalisation et de décodage sur des treillis très réduits en complexité, et de réduire corrélativement la complexité calculatoire de ce récepteur, tout en conservant des performances d'égalisation et de décodage proches d'un processus d'égalisation et de décodage optimal.

Le procédé et le système de codage d'un flux de données numériques codées par combinaisons spatio-temporelles en émission et en réception multiple, objets de la présente invention, consiste à, respectivement permet de soumettre le flux initial de données numériques à un codage externe au moyen d'un premier code de rendement déterminé, pour engendrer un flux numérique codé, subdivisé en blocs successifs, soumettre ce flux numérique codé à un processus d'entrelacement par blocs pour engendrer un flux numérique codé entrelacé présentant une diversité temporelle, soumettre ce flux numérique codé et entrelacé à un démultiplexage, ce flux numérique codé et entrelacé étant ainsi subdivisé en un nombre ν de flux numériques codés entrelacés élémentaires, soumettre chaque flux numérique codé entrelacé élémentaire à un codage interne au moyen d'au moins un deuxième code de rendement déterminé, pour engendrer un ensemble de flux numériques élémentaires codés par combinaisons spatio-temporelles, transmettre chaque flux numérique élémentaire,subdivisé en symboles sur un canal de transmission au moyen d'une antenne d'émission distincte, l'ensemble de ces antennes d'émission formant un réseau à diversité spatiale, pour engendrer un ensemble de flux numériques élémentaires transmis présentant une diversité spatiale et temporelle. Ceci permet, à la réception, d'effectuer un décodage du flux de données numériques codées par combinaisons spatio-temporelles constitué par l'ensemble de flux numériques élémentaires transmis, à partir d'informations a priori représentatives de la diversité spatiale et temporelle.

Le procédé et le système de décodage d'un flux de données numériques codées par combinaisons spatio-temporelles en émission et en réception multiple, conformément au procédé précédemment cité, objets de la présente invention, s'appliquent à un ensemble de flux numériques transmis après codage selon ce procédé. Le procédé et le système de décodage selon l'invention consistent à, respectivement permettent de recevoir le flux de données numériques codées par combinaisons spatio-temporelles constitué par l'ensemble de flux numériques transmis sur un canal de transmission sur une pluralité d'antennes de réception, ces antennes de réception pouvant être inférieures ou égales en nombre au nombre ν de voies de multiplexage et d'antennes d'émission formant un réseau d'antennes de réception à diversité spatiale, pour engendrer un ensemble de flux élémentaires de symboles de modulation reçus, soumettre cet ensemble de flux élémentaires de symboles de modulation reçus à un processus itératif d'égalisation du canal de transmission et de décodage conjoint, au moyen du deuxième code interne à partir d'un flux d'information extrinsèque sur les bits codés par le premier code externe et entrelacés, ce flux d'information extrinsèque sur les bits codés par le premier code externe et entrelacés constituant une information a priori issue d'un décodage à partir de ce premier code externe, pour engendrer un premier flux d'information extrinsèque sur les bits codés par le premier code externe et entrelacés, soumettre ce premier flux d'information extrinsèque à un désentrelacement, pour engendrer un deuxième flux d'information extrinsèque sur les bits codés en provenance du processus d'égalisation et de décodage conjoint, soumettre ce deuxième - flux d'information extrinsèque sur les bits codés à un décodage à partir du premier code externe, pour engendrer un troisième flux d'information extrinsèque sur les bits codés, issu du décodage à partir du premier code externe, soumettre ce troisième flux d'information extrinsèque à un entrelacement pour engendrer un troisième flux d'information extrinsèque à un entrelacement, pour engendrer le flux d'information extrinsèque sur les bits codés par le premier code externe et entrelacés, constituant l'information a priori, réinjecter cette information a priori dans le processus itératif d'égalisation du canal de transmission et de décodage conjoint.

Le procédé et le système de codage/décodage, objets de la présente invention, trouvent application à la mise en oeuvre d'interfaces radiofréquences dans tous les domaines, tels que, notamment, la radiotéléphonie mobile à très haut débit, la liaison sans fil entre appareillage électronique d'installations en environnement domestique ou industrie'.

Ils seront mieux compris à la lecture de la description ci-après et à l'observation des dessins dans lesquels :

- la figure 1a représente, à titre illustratif, un organigramme du procédé de codage de flux de données numériques codées par combinaisons spatio-temporelles, en émission et réception multiples, conformément à l'objet de la présente invention ;
- la figure 1b représente, à titre illustratif, un organigramme du procédé de codage de flux de données numériques codées par combinaisons spatio-temporelles, en émission et réception multiples, conforme à l'objet de la présente invention, dans lequel les antennes d'émission sont regroupées en groupes d'antennes spécifiques ;

- la figure 2a représente, à titre illustratif, un organigramme du procédé de codage de flux de données numériques codées par combinaisons spatio-temporelles, en émission et réception multiples, conformément au procédé de codage illustré en figure 1a ou 1b ;
- la figure 2b représente, à titre illustratif, un détail de réalisation d'un processus itératif d'égalisation et de décodage conjoint à entrée/sortie souple mis en oeuvre dans le cadre du procédé de décodage objet de l'invention représenté en figure 2a ;
- la figure 2c représente, à titre illustratif, un détail de mise en oeuvre d'un processus de décodage à entrée/sortie souple, à partir d'un code externe, permettant d'obtenir un flux d'information extrinsèque sur les bits codés, issus du décodage à partir du premier code externe ;
- la figure 3a représente, à titre illustratif, un schéma fonctionnel d'un système de codage de flux de données codées par combinaisons spatio-temporelles en émission et en réception, conformément à l'objet de la présenté invention ;
- la figure 3b représente, à titre illustratif, un schéma fonctionnel d'un système de codage de flux de données codées par combinaisons spatio-temporelles en émission et en réception, conforme à l'objet de la présente invention tel que représenté en figure 3a, dans lequel les antennes d'émissions sont regroupées en groupes d'antennes formant un réseau d'antennes à diversité spatiale ;
- la figure 4 représente, à titre illustratif, un schéma fonctionnel d'un système de codage de flux de données codées par combinaisons spatio-temporelles en émission et en réception, conforme à l'objet de la présente invention ;
- les figures 5a, 5b et 5c représentent des diagrammes de simulation de la valeur du taux d'erreur de bits BER (bit error rate en langage anglo-saxon) en fonction du rapport signal à bruit, exprimé en dB, pour un canal de transmission sévère, valeurs obtenues pour différentes conditions de mise en oeuvre du procédé de codagedécodage objet de l'invention.

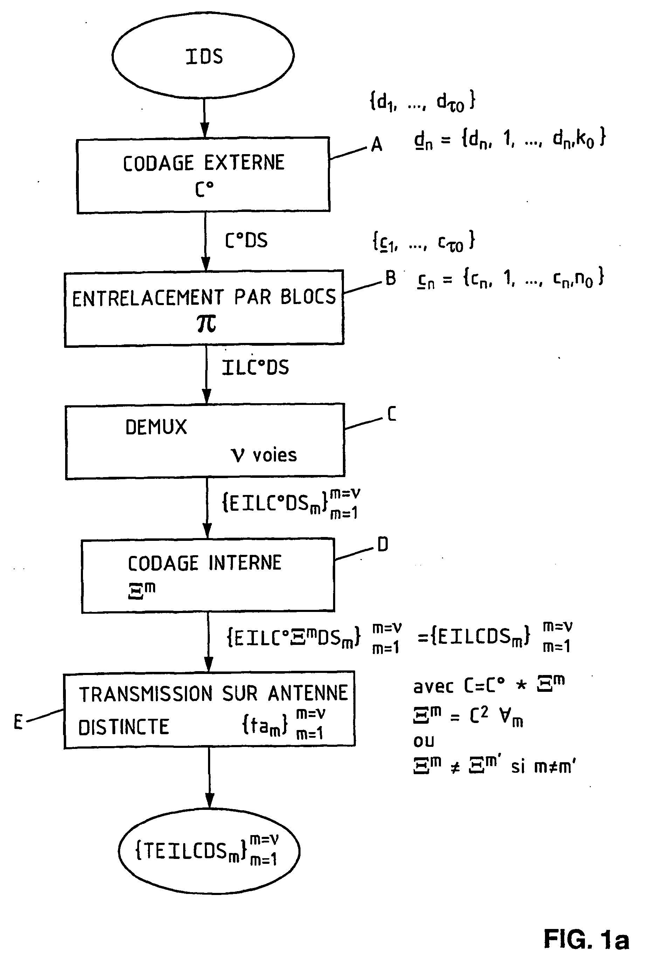

Une description plus détaillée du procédé de codage de flux de données numériques codées par combinaisons spatio-temporelles en émission et en réception multiple, conforme à l'objet de la présente invention, sera maintenant donnée en liaison avec la figure 1a.

En référence à la figure précitée, on indique que le procédé de codage objet de la présente invention, s'applique à un flux de données initial, noté IDS, constituant une séquence de données externes notées $\{\underline{d}_1,...\underline{d}_{\tau0}\}$, cette séquence de données externes correspondant à des symboles constitués par des bits successifs, notés $\underline{d}_n = \{d_{n,1}, ...d_{n,k0}\}$.

On rappelle que pour la transmission de données numériques codées, la subdivision de ces données numériques en symboles constitués par un certain nombre déterminé de bits successifs permet d'assurer une modulation de canal en vue de la transmission de ces symboles et, en définitive, de la séquence de données constituée par ces derniers indépendamment de toute valeur significative de la séquence constituée par cette séquence.

Ainsi qu'on l'observera sur la figure 1a, le flux initial de données numériques IDS est soumis, en une étape A, à un codage externe au moyen d'un premier code de rendement déterminé pour engendrer un flux numérique codé. Sur la figure la précitée, le premier code permettant d'effectuer le codage externe est noté $C^0$.

D'une manière plus spécifique, on indique que le premier code externe peut avantageusement être constitué par un code en treillis ou, de manière équivalente, par une combinaison de codes en treillis. Le flux numérique codé obtenu suite à l'étape A est noté $C^0DS$ sur la figure 1a. Il consiste en une séquence codée externe, notée $\{\underline{c}_1,...,\underline{c}_{\tau0}\}$, cette séquence codée externe consistant en des symboles de bits codés notés $\underline{c}_n=\{c_{n,1},...,c_{n,n0}\}$ où $c_{n,1}$ à $c_{n,n0}$ dénotent les bits successifs constitutifs du symbole codé $\underline{c}_n$.

Le flux numérique codé $C^0DS$ est ensuite soumis à une étape B, après une subdivision en blocs successifs par exemple, à un processus d'entrelacement par blocs pour engendrer un flux numérique codé entrelacé, noté $ILC^0DS$, présentant ainsi, du fait, d'une part, du codage externe à l'étape A et de l'entrelacement, d'autre part, une diversité temporelle.

D'une manière générale, on indique que le processus d'entrelacement par blocs à l'étape B peut être mis en oeuvre au moyen d'un système entrelaceur aléatoire noté $\pi$.

L'étape B est elle-même suivie d'une étape C consistant à soumettre le flux numérique codé et entrelacé $ILC^0DS$ à un démultiplexage, le flux numérique codé et entrelacé $ILC^0DS$ étant par cette opération subdivisé en un nombre donné $\nu$ de flux numériques codés entrelacés élémentaires, l'ensemble de ces flux numériques codés entrelacés élémentaires étant noté sur la figure 1a :

$$\left\{EILC^0DS_m\right\}_{m=1}^{m=\nu}$$

On conçoit que chaque flux numérique entrelacé élémentaire constitue en fait une couche de rang m, laquelle, conformément au procédé de codage objet de la présente invention, outre la qualité de diversité temporelle introduite du fait du codage externe et de l'entrelacement, permet, ainsi qu'il sera décrit ultérieurement dans la description, d'introduire un codage spatial spécifique.

L'étape C précitée est alors suivie d'une étape D consistant à soumettre chaque flux numérique codé entrelacé élémentaire, c'est-à-dire chaque signal au niveau de chaque couche de rang $m \in [1, \nu]$ à un processus de codage interne au moyen d'au moins un deuxième code noté $\Xi^m$ de rendement déterminé, pour engendrer un ensemble de flux numériques élémentaires codés par combinaison spatio-temporelle. Suite à l'étape D précitée, l'ensemble de flux élémentaires codés par combinaison spatio-temporelle est noté :

$$\left\{EILC^0\Xi^m DS_m\right\}_{m=1}^{m=\nu} .$$

L'expression de l'ensemble de flux numériques élémentaires codés par combinaison spatio-temporelle est simplifiée selon la relation :

$$\left\{EILCDS_m\right\}_{m=1}^{m=\nu} \ avec \ C=C^0 \ * \ \Xi^m$$

le signe * désignant la combinaison du code externe et du codage interne appliqué à chacun des flux numériques codés entrelacés élémentaires, c'est-à-dire à chacun des signaux numériques transmis par chaque couche de rang m, compte tenu bien entendu de l'opération d'entrelacement réalisée à l'étape B. Cette combinaison peut être analysée en un produit du code externe et du codage interne, ainsi qu'il sera décrit ci-après.

A la fin de l'étape de codage interne D, on dispose de l'ensemble des flux numériques élémentaires codés par combinaisons spatio-temporelles du fait de la subdivision en couches de rang m et du codage interne spécifique combiné au codage externe précité.

L'étape D est elle-même suivie d'une étape E consistant à transmettre chaque flux numérique élémentaire constitué en symboles $EILCDS_m$ précédemment mentionné sur un canal de transmission au moyen d'une antenne d'émission distincte.

Conformément à un aspect remarquable du procédé objet de la présente invention, l'ensemble des antennes d'émission distinctes, noté $\left\{ta_m\right\}_{m=1}^{m=\nu}$, forme un réseau à diversité spatiale et permet en conséquence d'engendrer, à partir de chaque flux numérique élémentaire codé par combinaison spatio-temporelle $EILCDS_m$, un ensemble de flux numériques élémentaires transmis présentant une diversité spatiale et temporelle, en raison, d'une part, des codages externes et codages internes introduits compte tenu de l'entrelacement par blocs, et de la répartition de l'émission sur l'ensemble des antennes d'émission distinctes, d'autre part.

En ce qui concerne ce dernier, on indique que cet ensemble d'antennes d'émission forme un réseau à diversité spatiale, chaque antenne d'émission distincts constitutive de ce réseau étant distante d'une antenne d'émission distincte voisine d'une distance supérieure à $\lambda_0$, où $\lambda_0$ désigne la longueur d'onde de l'onde porteuse permettant d'assurer la transmission par modulation de chacun des flux numériques élémentaires codés par combinaisons spatio-temporelles obtenus à l'issue de l'étape D.

Le procédé de codage objet de la présente invention permet, à la réception, d'effectuer un décodage du flux de données numériques codées par combinaisons spatio-temporelles constituant l'ensemble de flux numériques élémentaires transmis à partir d'informations a priori représentatives de la diversité spatiale et temporelle introduite au codage.

Différents éléments de mise en oeuvre des étapes C, D du procédé objet de la présente invention illustré en figure la seront maintenant donnés ci-après.

De manière préférentielle, on indique que, pour chaque couche de rang $m \in [1, \nu]$, chaque flux numérique codé entrelacé élémentaire est constitué en une trame, laquelle est à son tour divisée en N salves comportant chacune $\tau$ symboles successifs, notées $\left\{\underline{u}_1^m, \cdots \underline{u}_\tau^m\right\}$, chaque symbole étant constitué par une succession de bits codés, notés $\underline{u}_n^m = \left\{u_{n,1}^m, ..., u_{n,km}^m\right\}$, à ces symboles étant ajoutés, de manière classique et connue en tant que telle, des bits de queue, ou *tail bits* en langage anglo-saxon, et, après codage interne, une séquence connue constituant une séquence d'apprentissage, en général des symboles de type CAZAC. On rappelle que les symboles d'apprentissage précités, connus en tant que tels, permettent, après transmission, d'effectuer une évaluation préalable de la réponse impulsionnelle du canal de transmission, le canal de transmission consistant en une pluralité de trajets de propagation entre l'émetteur et le récepteur, chaque trajet constituant un canal de transmission élémentaire.

Ainsi, suite à l'étape C, chaque salve constitutive des flux numériques codés entrelacés élémentaires de rang m successif est soumise au codage $\Xi^m$, lequel permet d'associer à chacun des symboles d'entrée $\underline{u}_n^m$ un symbole codé, formé par une succession de bits et noté $\underline{x}_n^m = \left\{ x_{n,1}^m, ..., x_{n,n(m)}^m \right\}$.

Les symboles codés précités $\underline{x}_n^m$ sont ensuite répartis par groupes de $q_t^m$ bits sur les $\eta_m$ branches de transmission distinctes, de sorte que, à chaque instant donné, la relation (1) est vérifiée :

$$n(m) = \sum_{t=1}^{\eta_m} q_t^m \qquad\qquad (1)$$

On rappelle que m désigne le rang de la couche, avec $1 \leq m \leq \nu$, et t désigne le rang de l'antenne d'émission associé au codage interne $\Xi^m$ de la couche m, avec $1 \leq t \leq \eta_m$, le nombre d'antennes $\eta_m$ par couche dépendant du rang de la couche et donc du codage $\Xi^m$.

En supposant une famille de modulation de type $Q_t^m$-aire, avec $Q_t^m = 2^{q_t^m}$, chaque groupe de $q_t^m$ bits sur chaque branche de transmission $t \in [1, \eta_m]$ est soumis à une modulation $Q_t^m$-aire produisnt un symbole complexe noté $z_n^{m,t}$.

Dans le cas de mise en oeuvre le plus général du procédé de codage objet de la présente invention, on indique que chaque codage interne mis en oeuvre à partir du deuxième code $\Xi^m$ peut être différent en fonction du rang m de chaque couche.

Dans une telle situation, cette diversité du codage interne est notée :

$$\Xi^m \neq \Xi^{m'} \text{ si } m \neq m'.$$

Au contraire, et dans un mode de réalisation particulier non limitatif, on indique que chaque deuxième codage interne $\Xi^m$ peut être identique pour chaque couche de rang m, cette condition étant notée :

$$\Xi^m = C^2 \; \forall \; m$$

sur la figure 1a.

D'une manière générale, on indique que le canal de transmission, pour un nombre $\eta = \sum_{m=1}^{\nu} \eta_m$ antennes de transmission et pour $\rho$ antennes de réception, est constitué par l'ensemble des trajets multiples relayant chaque antenne de transmission à une antenne de réception.

Dans ces conditions, et en raison de la propagation multi-trajets et du caractère variable du canal de transmission en raison de la mobilité entre l'émetteur et le récepteur, un canal radiofréquences sélectif en fréquence et variable dans le temps peut être modélisé par la réponse impulsionnelle en temps discret du canal équivalent, incluant bien entendu les filtres d'émission et de réception de mise en forme utilisés habituellement, chaque canal de transmission élémentaire correspondant étant noté pour cette raison :

$$\underline{h}^{m,t,r} = \left\{ h_0^{m,t,r}, \ldots, h_{\chi c-1}^{m,t,r} \right\}$$

pour chaque trajet reliant une antenne d'émission de chaque couche m à une antenne de réception de rang r donné.

Dans la relation précédente, $\chi_c$ désigne la longueur de contrainte en nombre de symboles transmis, longueur de contrainte représentative de la mémoire du canal.

Tous les canaux élémentaires sont considérés présenter la même longueur de contrainte $\chi_c$. Une telle supposition est admissible car le nombre de composants de trajets multiples individuels est essentiellement déterminé par les structures larges et les objets réfléchissants.

Si, conformément au procédé objet de la présente invention, on prend en considération la transmission salve par salve, alors, les canaux de transmission élémentaires et le canal de transmission résultant sont statiques pendant la durée de transmission d'une salve et changent de manière indépendante d'une salve à l'autre. Dans ces conditions, la valeur $\tau$ peut être considérée, en première approximation, comme une mesure du temps de cohérence du canal précité. Ces conditions permettent d'établir une modélisation acceptable pour des canaux quasi statiques multi-trajets à évanouissement de fréquence lentement variables et à saut de fréquence.

Les coefficients de chaque canal élémentaire, notés $\left\{ h_k^{m,t,r} \right\}_k$, peuvent, dans ce cas, être considérés comme des variables aléatoires complexes gaussiennes indépendantes, de même énergie moyenne nulle, vérifiant la relation (2):

$$\sum_{k=0}^{\chi_c-1} \left\| h_k^{m,t,r} \right\|^2 = 1 \qquad (2)$$

A chaque temps d'échantillonnage discret n, chaque antenne de réception de rang r observe, dans ces conditions, un ensemble de symboles transmis correspondant au flux numérique élémentaire transmis $\left\{ TEILCDS_m \right\}_{m=1}^{m=\nu}$ et vérifiant la relation (3) :

$$y_n^r = \sum_{m=1}^{\nu} \sum_{t=1}^{\eta_m} \sum_{k=0}^{\chi_c-1} h_k^{m,t,r} z_{n-k}^{m,t} + \varsigma_n^r \qquad (3)$$

Dans cette relation $\varsigma_n^r$ représente un échantillon de bruit complexe de valeur moyenne nulle et de variance $2\sigma^2$.

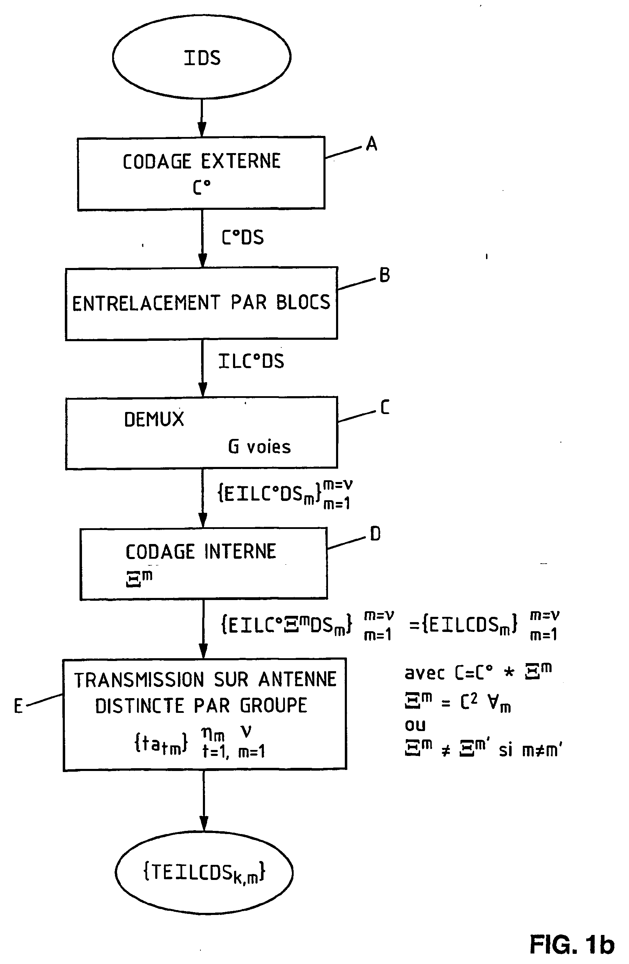

Sur la figure 1b, on a représenté une variante de mise en oeuvre du procédé de codage objet de la présente invention dans lequel les étapes A, B, C et D sont identiques mais où, toutefois, le nombre de voies de multiplexage et le nombre d'antennes d'émission distinctes sont différents.

Dans ce mode de mise en oeuvre, les antennes d'émission sont regroupées par groupes d'antennes d'émission, chaque groupe d'antenne, noté $\left\{ ta_{tm} \right\}_{t=1,m=1}^{\eta_m \ \nu}$. Ainsi, chaque flux numérique élémentaire codé par combinaison spatio-temporelle issu de l'étape D, noté $EILCDS_m$, est transmis à chaque groupe d'antennes, chaque groupe d'antennes d'émission distinctes de chacun des codes du type modulation codée en treillis spatio-temporelle $\Xi^m$ formant un sous-réseau d'antennes à diversité spatiale, la distance entre chaque antenne de chaque groupe étant inférieure à $\lambda_0$, $\lambda_0$ désignant la longueur d'onde de l'onde porteuse.

De la même manière que dans le cas de la figure 1a, le deuxième codage interne $\Xi^m$ peut être unique pour chacun des groupes, cette relation étant notée $\Xi^m = C^2 \ \forall \ m$, ou distincte pour chacun des groupes et, en définitive, pour chacune des couches de rang m, les différents codages internes mis en oeuvre étant alors notés $\Xi^m \neq \Xi^{m'}$ si $m \neq m'$.

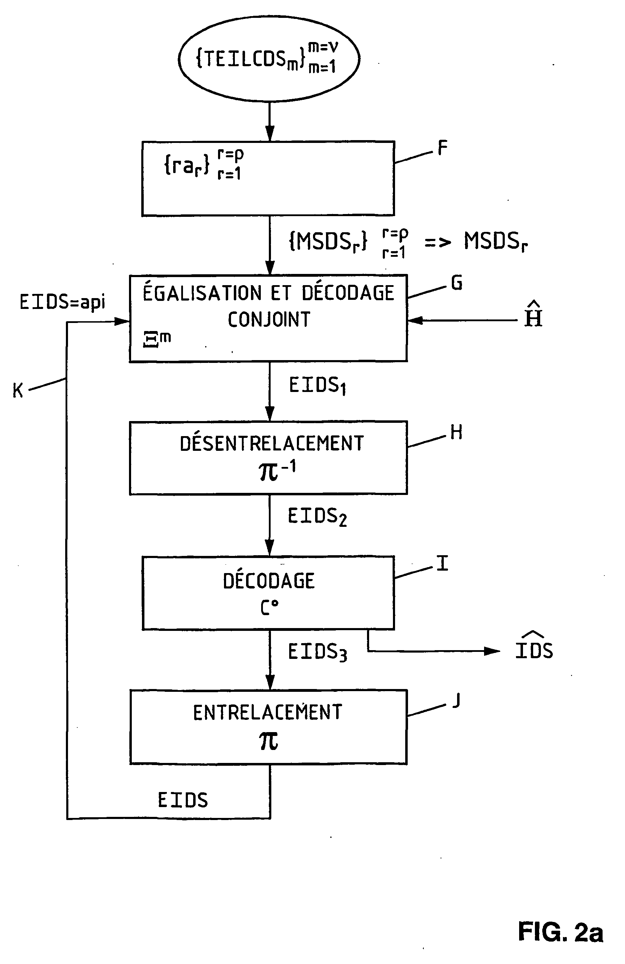

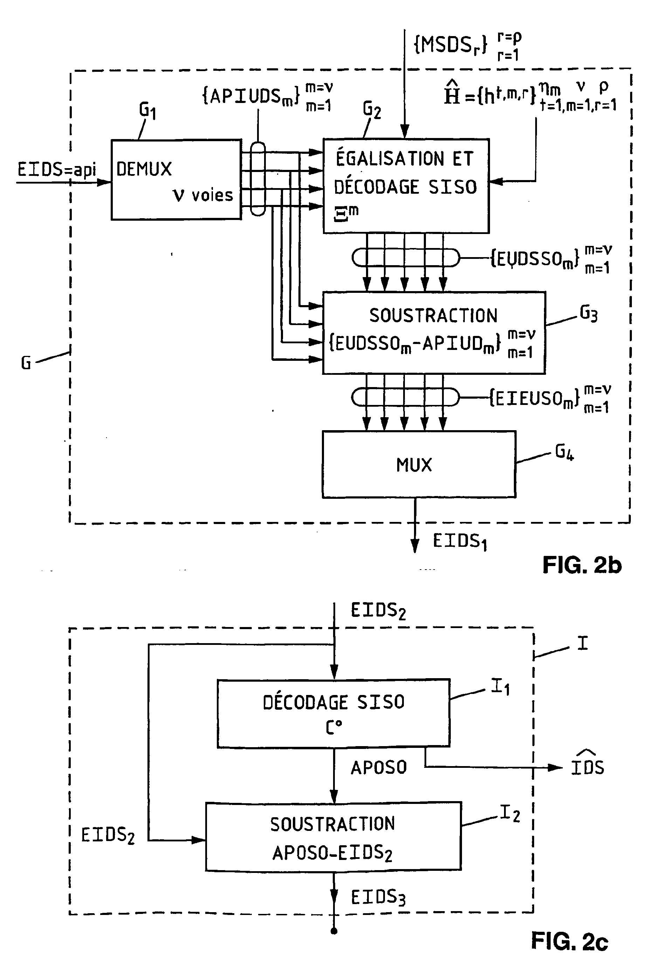

Un procédé de décodage d'un flux de données numériques codées par combinaisons spatio-temporelles en émission et en réception multiple, le codage de ce flux numérique ayant été effectué conformément au procédé de codage objet de la présente invention tel que décrit en relation avec les figures 1a et 1b précitées, sera maintenant décrit en liaison avec les figures 2a, 2b et 2c.

En raison du codage de ces données numériques conformément au procédé objet de la présente invention précédemment décrit, on indique que le procédé de décodage, objet de l'invention, consiste, en une étape F, à recevoir le flux de données numériques codées par combinaisons spatio-temporelles constitué par l'ensemble de flux numériques élémentaires transmis sur un canal de transmission, cet ensemble de flux numériques élémentaires transmis étant noté $\{\mathbf{TEILCDS_m}\}_{m=1}^{m=\nu}$ , cette réception étant effectuée sur une pluralité $\rho$ d'antennes de réception. Sur la figure 2a, l'ensemble des antennes de réception est noté $\{\mathbf{ra_r}\}_{r=1}^{r=\rho}$

Ces antennes de réception, en nombre indépendant du nombre d'antennes d'émission, peuvent être en nombre inférieur $\eta$ ou égal au nombre $\eta$ d'antennes d'émission et forment, conformément à un aspect avantageux du procédé de décodage, objet de la présente invention, un réseau d'antennes de réception à diversité spatiale, pour définir un ensemble de flux élémentaires de symboles de modulation reçus, cet ensemble de flux élémentaires de symboles de modulation reçus étant noté, à l'issue de l'étape F de la figure 2a, $\{\mathbf{MSDS_r}\}_{r=1}^{r=\rho}$ . On comprend en particulier que chaque symbole de modulation reçu est un symbole de la forme $\mathbf{y_n^r}$ vérifiant la relation (3) précédemment mentionnée dans la description.

L'étape F est alors suivie d'une étape G consistant à soumettre l'ensemble des flux élémentaires de symboles des modulation reçus $\{\mathbf{MSDS_r}\}_{r=1}^{r=\rho}$ à un processus itératif d'égalisation du canal de transmission et de décodage conjoint au moyen dudit deuxième codage interne $\Xi^m$ à partir d'un flux d'information extrinsèque sur les bits codés par le premier code externe et entrelacés, ce flux d'information extrinsèque étant issu d'un décodage à partir du premier code externe. Sur la figure 2a, le flux d'information extrinsèque sur les bits codés par le premier code externe et entrelacés est noté EIDS = api. En effet, ce flux d'information constitue une information a priori sur les bits codés et le processus d'égalisation et de décodage conjoint, mis en oeuvre à l'étape G à partir du deuxième codage externe $\Xi^m$, permet d'engendrer un premier flux d'information extrinsèque sur les bits codés par le premier code externe et entrelacés, ce premier flux d'information extrinsèque étant noté EIDS$_1$ sur la figure 2a.

L'étape G précitée est suivie d'une étape H consistant à soumettre le premier flux d'information extrinsèque EIDS$_1$ à un désentrelacement, pour engendrer un deuxième flux d'information extrinsèque sur les bits codés en provenance du processus d'égalisation et de décodage conjoint, ce deuxième flux d'information extrinsèque étant noté EIDS$_2$ sur la figure 2a. L'opération de désentrelacement est l'opération inverse de l'opération d'entrelacement réalisée lors de la mise en oeuvre du procédé de codage, objet de la présente invention, ce processus de désentrelacement étant noté, pour cette raison, $\pi^{-1}$ sur la figure 2a.

Le deuxième flux d'information extrinsèque sur les bits codés EIDS$_2$ est alors soumis, à l'étape I, à un décodage à partir du premier code externe C$^0$ pour engendrer un troisième flux d'information extrinsèque sur les bits codés, noté EIDS$_3$, issu du décodage à partir du premier code externe C$^0$. On note que, lors de cette opération I, le décodage fournit en outre une estimation de la valeur du signal numérique initial, noté pour cette raison ÎDS.

Suite à l'étape I, le troisième flux d'information extrinsèque est soumis à une opération d'entrelacement à l'étape J pour engendrer le flux d'information extrinsèque sur les bits codés par le premier code externe et entrelacés EIDS constituant l'information a priori sur les bits codés, notée api. Cette information a priori est alors réinjectée à l'étape K, symbolisée par la boucle de retour, dans le processus itératif d'égalisation du canal de transmission et de décodage conjoint, c'est-à-dire à l'étape G de la figure 2a.

En référence à la figure 2a, on comprend en particulier que le procédé de décodage, objet de la présente invention, consiste essentiellement à effectuer une détection conjointe multicouche des données codées et un décodage interne spatio-temporel, cette égalisation et ce décodage conjoint étant associés de manière itérative au décodage externe au moyen du premier code C$^0$ pour bénéficier de l'information a priori sur les bits codés api issue de la mise en oeuvre successive des étapes G, H, I et J. On comprend en particulier que le flux d'information extrinsèque sur les bits codés par le premier code externe et entrelacés, le flux noté EIDS sur la figure 2a, et constituant l'information a priori sur les bits codés api, est une information relative à chaque bit constitutif des symboles $\mathbf{z_n^{m,t}}$ constituant le signal reçu à l'issue de l'étape F. Ainsi, cette information a priori constitue une information effective quant à la valeur des bits constitutifs des symboles précités et, en définitive, de la diversité spatiale et temporelle introduite par le processus de codage et d'émission conforme à l'objet de la présente invention.

Une description plus détaillée d'un mode particulier de mise en oeuvre du procédé de décodage objet de la présente invention sera maintenant donnée en liaison avec les figures 2b et 2c.

Dans le mode de réalisation spécifique précité, on indique que ce dernier correspond à la mise en oeuvre d'un processus d'égalisation et de décodage à entrée et sortie pondérée, dit de type SISO (*soft input soft output*, en langage anglo-saxon).

Dans ces conditions, l'information a priori réinjectée dans le processus d'égalisation et de décodage conjoint de type SISO est constituée, de manière avantageuse, par une valeur logarithmique du rapport de probabilité a priori de la valeur des bits codés, cette valeur logarithmique constituant l'information extrinsèque sur les bits codés par le premier code externe et entrelacés.

Ainsi que représenté en figure 2b, et pour un deuxième codage interne $\Xi^m$ du type modulation codée en treillis spatio-temporel, le processus G d'égalisation et de décodage conjoint consiste à démultiplexer, en une étape $G_1$, le flux d'information extrinsèque sur les bits codés par le premier code externe et entrelacés EIDS constituant l'information a priori api en un ensemble de flux d'information a priori sur les bits de trames utilisateur subdivisées en paquets, cet ensemble de flux d'information a priori sur les bits de trames utilisateur étant noté $\{APIUDS_m\}_{m=1}^{m=\nu}$ sur la figure 2b.

L'étape $G_1$ est alors suivie d'une étape $G_2$ consistant à effectuer une égalisation et un décodage conjoint à entrée/sortie souple, c'est-à-dire de type SISO, appliqués à un treillis réduit en nombre d'états au moyen du deuxième codage $\Xi^m$. Ce treillis est défini comme le produit des treillis combinés des modulations codées en treillis spatio-temporel et des canaux à mémoire élémentaire s'y rapportant, eux-mêmes réduits en nombre d'état, pour engendrer un flux de sorties pondérées sur les bits des trames utilisateur, ce flux de sorties pondérées sur les bits des trames utilisateur étant noté $\{EUDSSO_m\}_{m=1}^{m=\nu}$ .

L'étape $G_2$ est suivie d'une étape $G_3$ consistant à extraire de chaque flux de sorties pondérées sur les bits des trames utilisateur $\{EUDSSO_m\}_{m=1}^{m=\nu}$ l'information a priori sur les bits des trames utilisateur $\{APIDUS_m\}_{m=1}^{m=\nu}$ correspondantes, pour engendrer un flux d'information extrinsèque sur les bits des trames utilisateur, noté $\{EIEUSO_m\}_{m=1}^{m=\nu}$ .

Lorsque le processus d'égalisation et de décodage mis en oeuvre à l'étape $G_2$ est un processus d'égalisation et de décodage de type SISO et que les entrées et sorties constituées par l'information a priori sur les bits des trames utilisateur $\{APIDUS_m\}_{m=1}^{m=\nu}$ , respectivement par les flux de sorties pondérées sur les bits des trames utilisateur $\{EUDSSO_m\}_{m=1}^{m=\nu}$ sont des valeurs logarithmiques de probabilité, le processus d'extraction peut être mis en oeuvre, en raison de la nature logarithmique de ces informations d'entrée/sortie, par une soustraction, tel que représenté à l'étape $G_3$ de la figure 2b.

Cette soustraction est notée :

$$\{EUDSSO_m - APIUD_m\}_{m=1}^{m=\nu} .$$

On constate ainsi que, d'une part, le processus d'égalisation et de décodage conjoint est effectué pour chaque couche de rang m et que, d'autre part, le processus d'extraction, et en particulier de soustraction dans le cas de la mise en oeuvre d'une égalisation et d'un décodage conjoint de type SISO, est également effectué pour chaque couche de rang m.

Suite à l'étape $G_3$, les flux d'information extrinsèque sur les bits des trames utilisateur $\{EIEUSO_m\}_{m=1}^{m=\nu}$ sont soumis à une opération de multiplexage $G_4$, pour engendrer le premier flux d'information extrinsèque sur les bits codés par le premier code externe et entrelacés, c'est-à-dire le flux $EIDS_1$.

De la même manière, ainsi que représenté en figure 2c, et lorsque le processus d'égalisation et de décodage conjoint mis en oeuvre à l'étape $G_2$ de la figure 2b est de type SISO, l'étape de décodage au moyen du premier code externe à l'étape I de la figure 2a peut consister de manière avantageuse à soumettre, en une étape $I_1$, le deuxième flux d'information extrinsèque sur les bits codés en provenance du processus d'égalisation et de décodage conjoint, flux d'information extrinsèque noté $EIDS_2$, à un décodage à entrée/sortie pondérée de type SISO au moyen du premier code externe $C^0$ pour engendrer un flux de sortie pondérée, noté APOSO, représentatif d'une information a posteriori sur les bits codés. L'étape $I_1$ est suivie d'une étape $I_2$ consistant à extraire le deuxième flux d'information extrinsèque du deuxième flux de sortie pondérée représentatif de l'information a posteriori sur les bits codés, pour engendrer le troisième flux d'information extrinsèque sur les bits codés $EIDS_3$. Dans le cas de la mise en oeuvre de l'étape $I_1$ sous forme d'un décodage SISO à partir du premier code externe $C^0$, l'étape d'extraction à l'étape $I_2$ est également une étape de soustraction en raison du caractère logarithmique des valeurs numériques constitutives des flux $EIDS_2$ et APOSO.

Un justificatif théorique du mode opératoire du procédé de décodage, objet de la présente invention, tel que décrit en liaison avec les figures 2a, 2b et 2c, sera maintenant donné ci-après.

D'une manière générale, on indique que le processus d'égalisation et de décodage conjoint mis en oeuvre à l'étape G, et de manière plus spécifique à l'étape $G_2$ de la figure 2b, est mis en oeuvre sur l'ensemble des couches de rang m sur chacune des $\nu$ salves concomitantes, successivement, pour calculer le premier flux d'information extrinsèque sur les bits codés par le premier code externe et entrelacés, c'est-à-dire le flux $EIDS_1$, à partir du flux d'information extrinsèque sur les bits codés par le premier code externe et entrelacés issu d'un décodage à partir du code externe $C^0$, le flux d'information extrinsèque précité EIDS, constituant l'information a priori sur les bits codés api.

On indique de manière classique que ce calcul est effectué à partir d'une estimation $\hat{H}$ des coefficients du canal de transmission, cette estimation étant obtenue à partir des symboles d'apprentissage reçus dans les flux élémentaires de symboles de modulation reçus $TEILCDS_m$.

Dans le cas, ainsi que représenté en figure 2b, où le processus d'égalisation et de décodage conjoint réalisé à l'étape $G_2$ est de type SISO à partir du deuxième codage interne $\Xi^m$, les entrées et sorties de ce décodage correspondant à des séquences de valeur logarithmique du rapport des probabilités extrinsèques sur chacun des bits de chaque symbole de modulation observé à partir de l'ensemble des N séquences de symboles observées par l'ensemble des antennes de réception, ces séquences observées étant notées $\left\{ y_1^r, ..., y_\tau^r \right\}_{r=1}^{r=\rho}$ et de longueur $\tau$ en nombre de symboles observés reçus, l'estimée $\hat{H}$ du canal de transmission s'exprime sous la forme d'un ensemble d'estimées des coefficients de chaque canal élémentaire d'une antenne de transmission à toutes les antennes de réception sous la forme $\hat{H} = \left\{ h^{t,m,r} \right\}_{t=1,m=1,r=1}^{\eta_m \quad \nu \quad \rho}$.

A la première itération du processus itératif d'égalisation et de détection conjointe, le calcul est effectué en l'absence de toute information préalable, les valeurs estimées des coefficients des canaux élémentaires étant simplement calculées à partir des séquences d'apprentissage et des séquences correspondantes obtenues sur les symboles de modulation observés. Les séquences de flux de sorties pondérées sur les bits de trames utilisateur $EUDSSO_m$ obtenues à l'issue de l'étape $G_2$ sont classées par trames, soumises à l'étape $G_3$ d'extraction et en particulier de soustraction à partir de l'information a priori api obtenue pour chacune des couches à partir de l'opération de démultiplexage $G_1$, les flux d'information extrinsèque sur les bits des trames utilisateur obtenus à l'issue de l'étape $G_3$ et notés $\left\{ EIEUSO_m \right\}_{m=1}^{m=\nu}$ étant ensuite soumis à l'opération de multiplexage de l'étape $G_4$, pour engendrer le premier flux d'information extrinsèque sur les bits codés par le premier code externe et entrelacés $EIDS_1$ précédemment cité.

L'opération de désentrelacement réalisée à l'étape H de la figure 2a sur le premier flux d'information extrinsèque sur les bits codés par le premier code externe et entrelacés permet alors d'engendrer le deuxième flux d'information extrinsèque sur les bits codés en provenance du processus d'égalisation et de décodage conjoint $EIDS_2$, lequel constitue une nouvelle séquence de valeurs logarithmiques de rapport de probabilité intrinsèque sur les bits codés, pour l'étape de décodage externe I à partir du code externe $C^0$.

L'étape I précitée de décodage à partir du code externe $C^0$ est alors effectuée, ainsi que représenté en figure 2c, par la succession des étapes $I_1$ et $I_2$ au moyen d'un décodage de type SISO et en particulier d'un algorithme BCJR dans le domaine logarithmique, l'étape de décodage $I_1$ permettant dans ces conditions d'évaluer la séquence des valeurs logarithmiques des rapports de probabilité extrinsèque sur chacun des bits de chacun des symboles codés par l'intermédiaire du premier code externe $C^0$. Cette séquence est obtenue suite à l'extraction par soustraction à l'étape $I_2$ du deuxième flux d'information extrinsèque sur les bits codés $EIDS_2$, du flux de sortie pondérée représentatif de l'information a posteriori sur les bits codés APOSO précités. Le troisième flux d'information extrinsèque sur les bits codés $EIDS_3$ représentatif de la valeur logarithmique des rapports de probabilité extrinsèque sur chacun des symboles codés par le premier code externe $C^0$ est ensuite soumis à l'étape J à un entrelacement pour engendrer l'information a priori EIDS = api. Cette information a priori api est alors réinjectée au niveau du processus d'égalisation et décodage SISO $G_2$ de la figure 2b, par l'intermédiaire d'un démultiplexage $G_1$ sur l'ensemble des $\nu$ voies ou trames utilisateur. L'ensemble des informations correspondantes pour chaque trame et suite à segmentation par salves, pour constituer l'ensemble de flux d'information a priori sur les bits de trames utilisateur divisées en salves ou paquets, est ainsi réintroduit au niveau du processus d'égalisation et de décodage conjoint $G_2$. Le processus d'égalisation et de décodage conjoint $G_2$ précité effectue alors l'égalisation et le décodage spatio-temporel sur n trames de $\nu$ séquences de valeur logarithmique de rapport de probabilité a priori sur les bits des symboles de modulation observés $\left\{\mathbf{MSDS_r}\right\}_{r=1}^{r=\rho}$ .

Le procédé objet de la présente invention tel que décrit en figure 2a et en particulier en figures 2b et 2c, permet d'imbriquer un processus additionnel de réestimation de chaque canal élémentaire distinct générateur d'interférences intersymboles dans le processus itératif classique de turbo-détection.

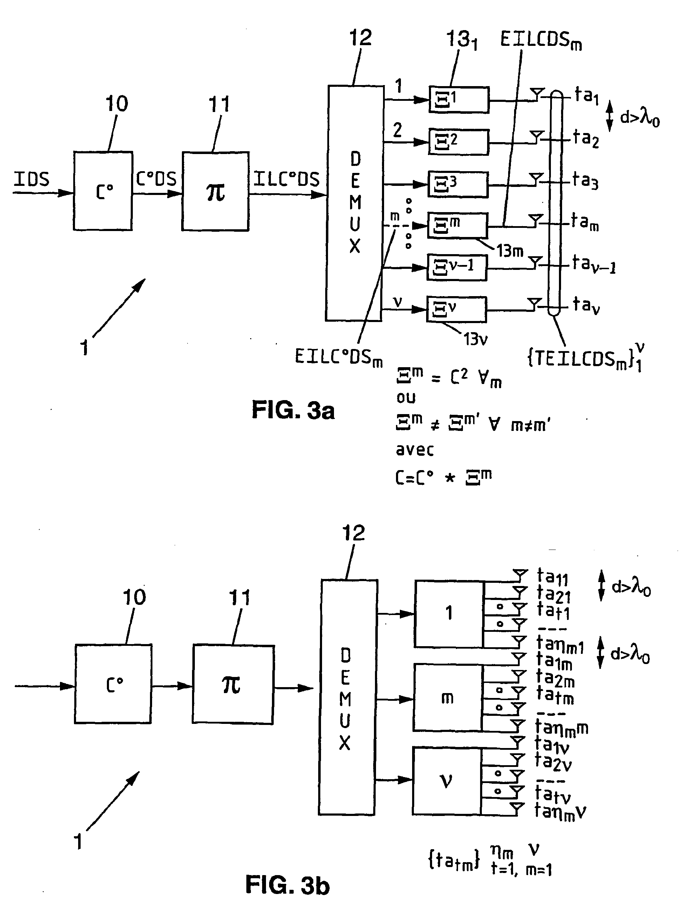

Une description plus détaillée d'un système de codage d'un flux de données numériques codées par combinaisons spatio-temporelles, en émission et en réception multiple, conforme à l'objet de la présente invention, sera maintenant donnée en liaison avec les figures 3a et 3b.

Ainsi que représenté sur la figure 3a, on indique que le système de codage, objet de la présente invention, comporte avantageusement un module 10 de codage externe d'un flux initial de données numériques à partir d'un premier code de rendement déterminé $C^0$, pour engendrer le flux numérique codé $C^0DS$ précédemment cité. Le module 10 de codage externe est suivi d'un module 11 d'entrelacement par blocs permettant, à partir du flux numérique codé $C^0DS$, d'engendrer un flux numérique codé entrelacé présentant, du fait, d'une part, du codage externe préalablement introduit et de l'entrelacement réalisé, d'autre part, une diversité temporelle spécifique. Le flux numérique codé entrelacé est noté $ILC^0DS$.

Ce module d'entrelacement 11 est lui-même suivi d'un module démultiplexeur 12 recevant le flux numérique entrelacé $ILC^0DS$, le module démultiplexeur 12 permettant d'engendrer un nombre $\nu$ de flux numériques codés entrelacés élémentaires, ces flux numériques codés entrelacés élémentaires étant subdivisés en trames, elles-mêmes subdivisées en salves, ainsi que décrit précédemment dans la description.

Sur la figure 3a, chaque flux numérique codé entrelacé élémentaire ou chaque trame constituant une couche de rang m est noté $EILC^0DS_m$.

Le système de codage objet de l'invention comporte en outre, ainsi que représenté en figure 3a, une pluralité de modules de codage, notés $13l$ à $13_\nu$, chaque module de codage permettant d'appliquer un codage interne à partir d'au moins un deuxième code de rendement déterminé, noté $\Xi^1, \cdots \Xi^m, \cdots \Xi^\nu$, chaque module de codage interne recevant un des flux numériques codés entrelacés élémentaires, c'est-à-dire une trame utilisateur, pour engendrer l'ensemble de flux numériques élémentaires codés par combinaisons spatio-temporelles, constitués en symboles notés $EILCDS_m$.

En outre, une pluralité d'antennes d'émission $\left\{\mathbf{ta_m}\right\}_{m=1}^{m=\nu}$ est prévue et permet d'assurer l'émission de chaque flux numérique élémentaire codé par combinaison spatio-temporelle et constitué en symboles, une antenne d'émission distincte de rang m assurant la transmission du flux numérique élémentaire $EILCDS_m$.

Selon un aspect remarquable du système de codage, objet de la présente invention, l'ensemble des antennes d'émission forme un réseau à diversité spatiale, chaque antenne d'émission $ta_m$ étant distante d'une antenne d'émission voisine $ta_m$, avec $m \neq m'$, d'une distance $d > \lambda_0$, ainsi que mentionné précédemment dans la description, $\lambda_0$ désignant la longueur d'onde de l'onde porteuse assurant la transmission des flux numériques élémentaires précités.

Compte tenu de la constitution de l'ensemble des antennes d'émission en un réseau d'antennes à diversité spatiale, le système objet de la présente invention permet ainsi d'engendrer un ensemble de flux numériques élémentaires transmis, noté $\left\{\mathbf{TEILCDSm}\right\}_{m=1}^{m=\nu}$, lequel présente une diversité spatiale et temporelle, en raison, d'une part, du codage externe introduit par le module de codage 10 et le module d'entrelacement 11 et, d'autre part, du traitement par couches de rang m de chaque trame, du codage spatio-temporel introduit par chaque module de codage interne $13_1$ à $13_\nu$ et de l'émission par chacune des antennes constitutives du réseau d'antennes précité.

La figure 3b représente un mode de réalisation particulier non limitatif du système de codage objet de la présente invention, tel que représenté en figure 3a où les mêmes références désignent bien entendu les mêmes éléments.

Toutefois, dans le mode de réalisation représenté en figure 3b, en particulier, le deuxième codage interne $\Xi^m$ de type modulation codée en treillis spatio-temporel permet d'engendrer un flux de symboles de modulation et les antennes d'émission distinctes sont arrangées en groupes d'antennes transmettant chacun un flux de symboles de modulation. Sur la figure 3b, chaque groupe d'antennes est réputé comporter $\eta_m$ antennes d'émission, les antennes correspondantes étant notées:

$$\mathbf{ta_{11}, \cdots, ta_{t1}, \cdots, ta_{\eta_1 1} \; ; \; ta_{1\nu}, \cdots, ta_{t\nu}, \cdots, ta_{\eta_\nu \nu}}$$

où t désigne le rang de l'antenne d'émission dans le groupe de la couche m et m désigne le rang du groupe d'antennes et également le rang du module de codage interne, $13_m$, permettant d'appliquer le codage interne $\Xi^m$. En outre, en référence à la figure 3b, on indique que chaque antenne d'émission distincte constitue dans le groupe d'antennes d'émission correspondant un réseau à diversité spatiale avec les autres antennes de ce même groupe, chaque antenne d'un même groupe étant distante d'une antenne voisine appartenant à ce même groupe d'une distance d supérieure à $\lambda_0$, ainsi que mentionné précédemment dans la description, les groupes d'antennes d'émission distinctes de chaque type de modulation codée en treillis spatio-temporel formant un sous-réseau d'antennes à diversité spatiale.

On comprend ainsi que, grâce à la mise en oeuvre du système de codage, objet de la présente invention, tel que représenté en figure 3a ou 3b, celui-ci permet d'assurer la transmission d'un ensemble de flux numériques élémentaires transmis présentant une diversité spatiale et temporelle, conformément au procédé de codage, objet de la présente invention. De manière non limitative, on indique que, dans le cas de la figure 3b, le nombre de groupes d'antennes et le nombre d'antennes par groupes peut avantageusement vérifier la relation $\eta = \sum_{m=1}^{\nu} \eta_m$ où $\eta$ désigne le nombre

total d'antennes d'émission.

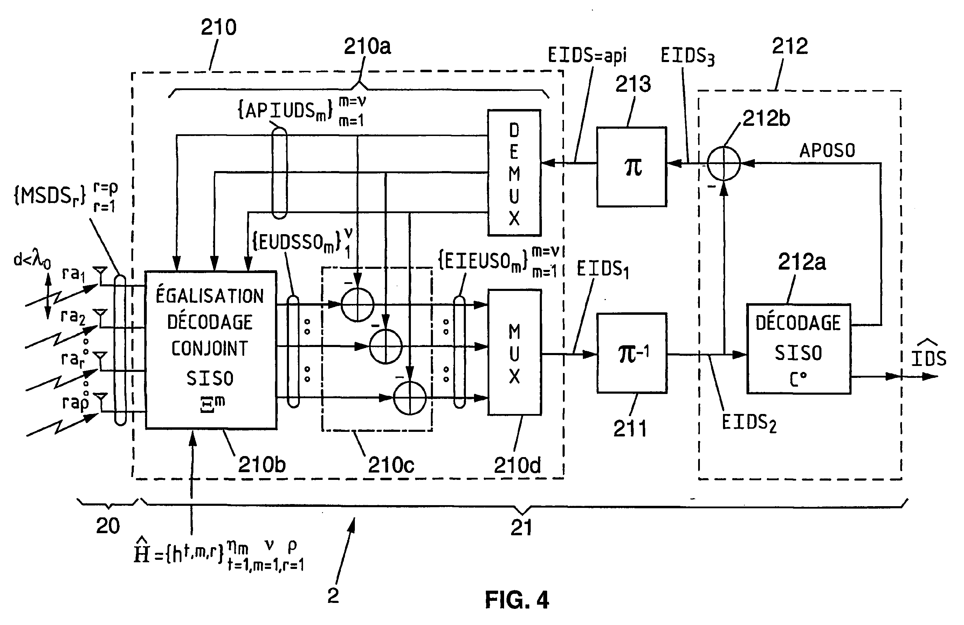

Une description d'un système de décodage d'un flux de données numériques codées par combinaisons spatio-temporelles, conformément au procédé de codage objet de l'invention, en émission et en réception multiple, ce flux de données numériques codées consistant au moins en un ensemble de flux numériques élémentaires transmis, ainsi que décrit précédemment dans la description, sera maintenant donnée en liaison avec la figure 4 et les figures suivantes.

En référence à la figure 4 précitée, le système de décodage objet de la présente invention comporte une pluralité d'antennes de réception, notées $\{ra_r\}_{r=1}^{r=\rho}$, ces antennes de réception permettant de recevoir l'ensemble de flux numériques élémentaires transmis par le canal de transmission constitué par l'ensemble des canaux de transmission élémentaires, ainsi que décrit précédemment dans la description.

Selon un aspect remarquable du système de décodage, objet de la présente invention, les antennes de réception précitées peuvent être en nombre inférieur ou égal au nombre $\nu$ d'antennes d'émission et forment un réseau d'antennes de réception 20 à diversité spatiale, pour définir un ensemble de flux élémentaires de symboles de modulation

reçus, noté $\{MSDS_r\}_{r=1}^{r=\rho}$. Le réseau 20 d'antennes de réception à diversité spatiale est suivi d'un module 21 de turbo-détection des flux élémentaires de symboles de modulation reçus précités par égalisation et détection conjointe et décodage itératif, ainsi que décrit précédemment dans la description relativement au procédé de décodage objet de la présente invention.

Ainsi que représenté de manière plus spécifique sur la figure 4, le module de turbo-détection 21 comporte un module 210 d'égalisation du canal de transmission et de décodage conjoint au moyen du deuxième codage interne $\Xi^m$ à partir d'un flux d'information extrinsèque sur les bits codés par le premier code externe et entrelacés, ce flux d'information extrinsèque étant issu d'un décodage à partir du premier code externe $C^0$ et constituant une information a priori sur les bits codés précédemment cités. Sur la figure 4, le flux d'information extrinsèque sur les bits codés par le premier code externe et entrelacés est noté EIDS = api en raison du fait que ce flux constitue en fait une information a priori api sur les bits codés.

Le module 210 d'égalisation du canal de transmission et de décodage conjoint permet, à partir des flux élémentaires de symboles de modulation reçus $MSDS_r$, d'engendrer un premier flux d'information extrinsèque $EIDS_1$ sur les bits codés par le premier code externe et entrelacés. Le module 210 d'égalisation du canal de transmission et de décodage conjoint est suivi d'un module 211 de désentrelacement, noté $\pi^{-1}$, du premier flux d'information extrinsèque $EIDS_1$ afin d'engendrer un deuxième flux d'information extrinsèque sur les bits codés $EIDS_2$ en provenance du module 210 d'égalisation et de décodage conjoint.

En outre, un module 212 de décodage à partir du premier code externe $C^0$ est prévu, lequel reçoit le deuxième flux d'information extrinsèque $EIDS_2$ délivré par le module d'entrelacement 211, afin d'engendrer un troisième flux d'information extrinsèque $EIDS_3$ sur les bits codés, ce troisième flux d'information extrinsèque étant issu du décodage à partir du premier code externe $C^0$.

Bien entendu, le module 212 de décodage à partir du premier code externe permet d'obtenir une estimée, notée ÎDS, du flux numérique initial IDS transmis, conformément au procédé de codage et grâce au système de codage objet de la présente invention, précédemment décrits dans la description.

Un module 213 d'entrelacement du troisième flux d'information extrinsèque $EIDS_3$ est également prévu, afin d'engendrer le flux d'information extrinsèque sur les bits codés par le premier code externe et entrelacés, noté IDS = api, constituant l'information a priori sur les bits codés, laquelle est réinjectée dans le module 210 d'égalisation du canal de transmission et de décodage conjoint.

Le système de décodage, objet de la présente invention, tel que représenté en figure 4, sera maintenant décrit de manière plus détaillée en référence à la même figure dans le cas où l'information a priori sur les bits codés est constituée par une valeur logarithmique du rapport de probabilité extrinsèque des bits codés précités, cette information a priori pouvant en particulier être obtenue lorsque le processus d'égalisation et de décodage conjoint est un processus de type SISO, c'est-à-dire à entrée et sortie souples.

En référence à la figure 4, on indique que le module 210 d'égalisation et de décodage conjoint comporte, dans le mode de réalisation précité, un module $210_a$ d'injection de l'information a priori api, comprenant un module démultiplexeur, noté DEMUX, de module démultiplexeur délivrant, à partir de l'information a priori précitée, constituée par le flux d'information extrinsèque sur les bits codés par le premier code externe et entrelacés EIDS = api, un ensemble de flux d'information a priori sur les bits de trames utilisateur, noté $\left\{\mathbf{APIDUS_m}\right\}_{\mathbf{m=1}}^{\mathbf{m=\nu}}$.

On comprend bien entendu qu'afin d'assurer une égalisation et un décodage conjoint par couches, c'est-à-dire par trames et par salves effectivement transmises, ainsi que décrit précédemment dans la description relativement au procédé de codage, objet de la présente invention, le modèle démultiplexeur DEMUX a pour objet de démultiplexer le flux d'information extrinsèque EIDS sur les bits codés par le premier code externe et entrelacés, constituant l'information a priori sur les bits codés, sur un même nombre $\nu$ de voies de démultiplexage que le nombre de flux numériques codés et entrelacés élémentaires engendrés à l'émission.

Dans ces conditions, le module 210 d'égalisation et de décodage conjoint comporte en outre un module $210_b$ de décodage à entrée et sortie pondérée, module SISO, lequel reçoit en entrée, d'une part, le flux d'information a priori sur les bits de trames utilisateur $\left\{\mathbf{APIDUS_m}\right\}_{\mathbf{m=1}}^{\mathbf{m=\nu}}$ et, d'autre part, les flux élémentaires de symboles de modulation

reçus $\left\{\mathbf{MSDS_r}\right\}_{\mathbf{r=1}}^{\mathbf{r=\rho}}$. Bien entendu, le module $210_b$ de décodage entrées/sorties pondérées reçoit également l'estimée des coefficients du canal de transmission $\hat{H} = \left\{h^{t,m,r}\right\}_{t=1,m=1,r=1}^{\eta_m \quad \nu \quad \rho}$ des coefficients des canaux de transmission élémentaire.

Le module de décodage $210_b$ délivre un flux de sorties pondérées sur les bits de trames utilisateur, noté

$$\left\{\mathbf{EUDSSO_m}\right\}_{\mathbf{m=1}}^{\mathbf{m=\nu}}$$

Le module $210_b$ est suivi d'une pluralité de modules soustracteurs, notée $210_c$, chaque module soustracteur permettant de soustraire de chaque flux de sorties pondérées sur les bits des trames utilisateur $\{EUDSSO_m\}$ l'information a priori sur les bits de trames utilisateur $\{APIUDS_m\}$ pour délivrer un flux d'information extrinsèque sur les bits des flux élémentaires utilisateur, noté $\left\{\mathbf{EIEUSO_m}\right\}_{\mathbf{m=1}}^{\mathbf{m=\nu}}$.

Un module multiplexeur $210_d$ est alors prévu, ce module multiplexeur recevant les flux d'information extrinsèque $EIEUSO_m$ sur les bits des trames utilisateur et délivrant le premier flux d'information extrinsèque sur les bits codés $EIDS_1$ par le premier code et entrelacés au module de désentrelacement 211.

En outre, en référence à la même figure 4, on indique que le module de décodage 212 à partir du premier code externe $C^0$ peut comprendre un module $212_a$ de décodage à entrées/sorties pondérées, recevant le deuxième flux d'information extrinsèque sur les bits codés $EIDS_2$ précité en provenance du processus d'égalisation et de décodage conjoint mis en oeuvre par le module 210, le module de décodage à entrées/sorties pondérées $210_a$ délivrant un flux de sorties pondérées représentatif d'une information a priori sur les bits codés APOSO. Le module $212_a$ est associé à un module soustracteur $212_b$ permettant de soustraire le flux de sorties pondérées représentatif d'une information a priori sur les bits codés APOSO, le deuxième flux d'information extrinsèque $EIDS_2$ pour délivrer le troisième flux d'information extrinsèque sur les bits codés $EIDS_3$ issu du décodage à partir du premier code externe $C^0$.

Un justificatif du mode opératoire du module $210_b$ d'égalisation et de décodage conjoint de type SISO sera maintenant donné ci-après, lorsque le deuxième codage interne est un codage de type modulation codée en treillis spatio-temporél ST-TCM.

Dans ces conditions, le processus d'égalisation/ décodage conjoint précité peut être considéré comme un module de Markov discret à nombre d'états fini, constitué par les $\nu$ codages ST-TCM élémentaires, suivi par $\eta$ filtres transversaux comportant $\chi_c$ coefficients chacun.

Pour chaque couche de rang m, chaque instant discret de rang n, instant d'échantillonnage, pour tout symbole

d'entrée observé $\underline{\mathbf{u}}_{\mathbf{n}}^{\mathbf{m}}$ comportant $k_m$ bits, le codage interne spatio-temporel $\Xi^m$ de longueur de contrainte $\chi_m$ produit

un symbole codé $\underline{\mathbf{x}}_{\mathbf{n}}^{\mathbf{m}}$ comprenant $n_m$ bits, lesquels sont dispersés et transmis en parallèle sur les $\eta_m$ voies ou antennes

de transmission.

Sur chacune des voies de transmission t, les bits de symboles $\underline{\mathbf{a}}_{\mathbf{n}}^{\mathbf{m,t}}$ sont mis en correspondance avec un symbole complexe précédemment désigné $z_n^{m,t}$ selon une règle de mise en correspondance conforme au codage ST-TCM, cette règle de mise en correspondance $\Xi^m$ étant encore désignée par *mapping rule* en langage anglo-saxon.

En conséquence, l'ensemble des symboles transmis selon leur représentation complexe $\left\{z_n^{m,t}\right\}_{t=1}^{t=\eta_t^m}$ est une fonction de l'état de codage spatio-temporel ST, état désigné par $v_n^m$ et de la séquence de symboles d'entrée $\underline{u}_n^m$. Dans ces conditions, la séquence des symboles complexes vérifie la relation (4) :

$$\left\{z_n^{m,t}\right\}_{t=1}^{\eta_t^m} = \psi\left(v_n^m ; \underline{u}_n^m\right) \qquad (4)$$

Pour un modèle de Markov discret à états finis, associé à toute couche de rang m incluant le treillis $\Xi^m$ et la mémoire du canal $\chi_c$-1 dont les états sont donnés par la relation (5):

$$s_n^m = \left\{\left\{z_{n-\chi_c+1}^{m,t}, \cdots, z_{n-1}^{m,t}\right\}_{t=1}^{\eta_m} ; v_n^m\right\} \qquad (5)$$

Dans ces conditions, l'ensemble des séquences de symboles complexes exprimé selon la relation (6) :

$$\left\{z_{n-\chi_c+1}^{m,t}, \cdots, z_{n-1}^{m,t}\right\}_{t=1}^{\eta_m} \qquad (6)$$

correspond à un trajet prenant en compte les processus de Markov combinés entre un état antérieur noté $s_{n-\chi_c+1}^m$ à l'état présent $s_n^m$, conformément à la loi de codage temporel selon les relations (7) et (8) :

$$v_{n+1}^m = \phi_v^m\left(v_n^m ; \underline{u}_n^m\right) \qquad (7)$$

$$\underline{x}_n^m = \phi_x^m\left(v_n^m ; \underline{u}_n^m\right) \qquad (8)$$

Dans les relations précédentes, on rappelle que $\underline{u}_n^m$ désigne les groupes de bits formant un symbole d'entrée et $v_n^m$ désigne les états du modèle de Markov précité, $\phi_v^m$ désignant la loi propre de codage temporel à chaque codage interne de rang m mis en oeuvre conformément à l'objet de la présente invention.

D'une manière générale, on indique que les lois de codage temporel sont considérées invariables dans le temps afin de simplifier l'explication du processus. Toutefois, une généralisation du processus à des lois de codage temporel variables dans le temps constitue une application envisageable au procédé de codage/décodage, objet de la présente invention, entrant dans le champ des équivalents de cette dernière.

En outre, entre des valeurs de temps discrètes n-1 et n, les transitions $b_n^m$ du modèle de Markov combiné correspondant peuvent être exprimées selon la relation (9) :

$$s_n^m : \underline{u}_n^m \to s_{n+1}^m \qquad\qquad (9)$$

et conduisent alors à un ensemble de symboles complexes transmis, exprimé sous la forme $\left\{z_n^{m,t}\right\}_{t=1}^{n_m}$ pour chacune des branches ou couches de transmission de rang m.

Dans ces conditions, en référence aux relations (7) et (8), l'état combiné du modèle obtenu peut être exprimé en termes de séquences de symboles codés de sortie de la forme $\left\{\underline{x}_{n-\chi_c+1}^m, \cdots, \underline{x}_{n-1}^m\right\}$ sous la forme de la relation (10) :

$$s_n^m = \left\{\left\{\underline{x}_{n-\chi_c+1}^m, \cdots, \underline{x}_{n-1}^m\right\} v_n^m\right\} \qquad\qquad (10).$$

De manière équivalente, ces séquences de symboles de sorties peuvent être exprimées en termes de séquences de symboles d'entrée, exprimées par $\left\{\underline{u}_{n-\chi_c+1}^m, \cdots, \underline{u}_{n-1}^m\right\}$ comme vérifiant la relation (11) :

$$s_n^m = \left\{v_{n-\chi_c+1}^m; \left\{\underline{u}_{n-\chi_c+1}^m, \cdots, \underline{u}_{n-1}^m\right\}\right\} \qquad\qquad (11)$$

Le mode opératoire du codage ST-TCM peut également être décrit par l'introduction d'états réduits $v_n^m$, lesquels consistent en une troncature de mémoire du plein état $v_n^m$ correspondant.

Pour une longueur de contrainte réduite $k_m < \chi_m$ du codage temporel, des lois de codage temporel peuvent être réécrites selon les relations (12) et (13):

$$v_{n+1}^m = \varphi_v^m\left(v_{n-(\chi_m-k_m)}^m; \left\{\underline{u}_{n-(\chi_m-k_m)}^m, \cdots, \underline{u}_n^m\right\}\right) \qquad\qquad (12)$$

$$\underline{x}_n^m = \varphi_x^m\left(v_{n-(\chi_m-k_m)}^m; \left\{\underline{u}_{n-(\chi_m-k_m)}^m, \cdots, \underline{u}_n^m\right\}\right) \qquad\qquad (13)$$

En référence aux relations (12) et (13) précédentes et de la même manière que précédemment relativement aux relations (7) et (8), l'état combiné du modèle de Markov peut être exprimé en termes de séquence de symboles d'entrée $\left\{\underline{u}_{n-\chi_c+1-(\chi_m-k_m)}^m, \underline{u}_{n-1}^m\right\}$ comme vérifiant la relation (14):

$$s_n^m = \left\{v_{n-\chi_c+1-(\chi_m-k_m)}^m; \left\{\underline{u}_{n-\chi_c+1-(\chi_m-k_m)}^m, \cdots, \underline{u}_{n-1}^m\right\}\right\} \qquad (14)$$

L'ensemble des relations précédentes, relatives au processus de codage interne mis en oeuvre dans le cas du procédé de codage, objet de la présente invention tel que décrit précédemment dans la description, permet de définir le treillis combiné associé au processus de codage élémentaire ST-TCM.

Le progression temporelle des séquences d'état produites par le processus de Markov combiné décrit précédemment peut être visualisé par un diagramme en treillis, noté $T^m$, dont les sommets et les transitions à toutes profondeurs ou sections de rang n, n désignant une variable de temps discret, correspondent aux états et transitions $\mathbf{s_n^m}$ et $\mathbf{b_n^m}$ définis précédemment. On note par $V^m$ et $B^m$ les sommets et l'espace des branches du diagramme en treillis $T^m$. On note également $\mathbf{V_n^m}$ et $\mathbf{B_n^m}$ l'espace des sommets et des branches à la profondeur et à la section n respectivement. On rappelle qu'une section est définie comme l'ensemble des branches contenues entre deux instants discrets de profondeurs adjacentes n, n-1.

On indique en outre que, lorsque le treillis est régulier, ainsi que supposé dans le cadre de la présente description, toute section de treillis $\mathbf{B_n^m}$ est suffisante pour décrire l'évolution du processus de Markov d'un temps discret n-1 à un temps discret n. En outre, au niveau de toute profondeur n du treillis selon la variable des temps discrets, l'espace des sommets $\mathbf{V_n^m}$ peut être identifié comme un seul espace d'état fini, constitué par tous les états possibles du processus de Markov combiné.

En définitive, en notant |.| la cardinalité de chaque espace et en raison du fait que, à chaque profondeur de rang n $2^{\kappa_m(\chi_c-1)}$ états d'interférence intersymboles sont combinés avec chaque état d'encodage, l'état de complexité du treillis combiné résultant vérifie la relation (15) :

$$\left|V_n^m\right| = 2^{\kappa_m(\chi_c-1)}\left|V_n^{m,stc}\right| \qquad\qquad (15)$$

Dans la relation (15) précédente, $\mathbf{V_n^{m,stc}}$ désigne l'état de l'espace du $m^{ième}$ treillis ST-TCM. En outre, en raison du fait que, à partir de chaque état émergent exactement $2^{\kappa_m}$ transitions, la complexité de l'espace des branches du treillis combiné à chaque section n vérifie la relation (16):

$$\left|B_n^m\right| = 2^{\kappa_m}\left|V_n^m\right| \qquad\qquad (16)$$

La généralisation de l'approche précédente à la totalité de la structure multicouches, c'est-à-dire de la structure constituée par les voies multiplexées et codées selon le codage interne à l'émission, peut être explicitée de la manière ci-après. Les états et les séquences d'entrée du modèle de Markov combiné sont assimilés à la concaténation des états ou des séquences d'entrée des processus de Markov élémentaires combinés modélisant chaque codage interne ST-TCM suivis par des sous-groupes de canaux correspondants générateurs d'interférences intersymboles.

Le treillis combiné associé à ce modèle, noté $T^{\otimes}$, est le produit cartésien $\otimes$ des $\nu$ treillis combinés $\left\{T^m\right\}_{m=1}^{m=\nu}$. Pour cette raison, les valeurs de complexité des espaces de branches et de sommets vérifient les relations (17) et (18):

$$\left|V_n^{\otimes}\right| = \prod_{m=1}^{\nu}\left|V_n^m\right| \qquad\qquad (17)$$

$$\left|B_n^{\otimes}\right| = \left|V_n^{\otimes}\right| \cdot \prod_{m=1}^{\nu} 2^{\kappa_m} \qquad (18)$$

Dans les relations précédentes, $V_n^{\otimes}, B_n^{\otimes}$ et $V_n^m, B_n^m$ désignent l'espace des sommets et des branches du treillis combiné $T^{\otimes}$ et du treillis élémentaire $T^m$ de rang m à chaque section $n \in [1,\tau]$.

La mise en oeuvre d'un module d'égalisation et de décodage conjoint dé type SISO, module $210_b$ sur la figure 4, pour réaliser le processus itératif d'égalisation et de décodage conjoint associé au décodage externe, a pour objet de calculer la valeur logarithmique du rapport de probabilité a posteriori de chaque bit constitutif de chaque symbole d'entrée $\underline{u}_n^m$ à chaque instant discret $n \in [1,\tau]$ et; bien entendu, pour chacune des couches $m \in [1,\nu]$.

Un tel calcul peut être mis en oeuvre de manière logicielle par exemple, par l'application de l'algorithme BCJR tel que décrit par L.R. BAHL, J. COCKE, F. JELINEK, J.RAVIV dans l'article intitulé *"Optimal Decoding of Linear Codes for Minimizing Symbol Error Rate"*, IEEE France. Inform. Theory, Vol.IT-20, pp. 284-287, March 1974. L'algorithme précité doit alors être appliqué sur l'ensemble du treillis combiné multicouches $T^{\otimes}(V^{\otimes},B^{\otimes})$.

Toutefois, les calculs et espace mémoire requis pour la mise en oeuvre de l'algorithme optimum précité étant sensiblement linéaires en fonction de la complexité de l'espace des branches $|B^{\otimes}|$, une telle approche de maximum a posteriori (MAP) se révèle très rapidement prohibitive en complexité et ne peut être mise en oeuvre en pratique.

Une possibilité, conformément à la mise en oeuvre du procédé de décodage et du système de décodage, objets de la présente invention, pour surmonter cette difficulté relative à la complexité, peut consister à restreindre chacun des treillis élémentaires combinés $T^m$ en sous-treillis, notés $T^m(V^m, B^m)$, ces sous-treillis étant obtenus par troncature de la longueur de contrainte effective $\chi_c$ des canaux de transmission élémentaires et réduction de cette dernière à une valeur arbitraire, la valeur $\kappa_m \in [1, \chi_c]$. La référence à l'indice m de la valeur arbitraire $\kappa_m$ indique que cette valeur peut varier d'une couche à la couche suivante.

Dans ces conditions, les sous-états de chaque sous-treillis $T^m$ sont définis selon la relation (19) :

$$s_n^m = \left\{ v_{n-\kappa+1}^m ; \left\{ \underline{u}_{n-\kappa_m+1}^m, \cdots, \underline{u}_{n-1}^m \right\} \right\} \qquad (19)$$

A titre d'exemple spécifique, on indique que lorsque la valeur arbitraire $\kappa_m$ est choisie égale à 1, les treillis élémentaires combinés sont réduits à des treillis ST-TCM purs.

Une réduction supplémentaire particulièrement avantageuse peut même être obtenue en réduisant la longueur de contrainte des codages temporels par exemple. Dans ce dernier cas, les treillis élémentaires combinés sont réduits à des sous-treillis de treillis ST-TCM purs.

Compte tenu du fait qu'une partie seulement de la mémoire des canaux de transmission et des codages élémentaires ST-TCM est prise en compte dans les sous-états des treillis multicouches combinés, les signaux modulés sous forme de symboles complexes transmis $\left\{z_n^{m,t}\right\}_{t=1}^{t=\nu}$ et impliqués dans le calcul des métriques de branches euclidiennes, mais qui toutefois ne sont pas directement accessibles, doivent être explicitement recalculés par la technique dite du traitement par survivant ou *per survivor processing PSP* en langage anglo-saxon.

Dans le but de réduire l'effet bien connu résultant de propagation d'erreurs, la technique PSP nécessite que les canaux de transmission de toutes les antennes de transmission à toutes les antennes de réception soient à minimum de phase. Malheureusement, ainsi que décrit dans la technique antérieure, il n'est habituellement pas possible de mettre en oeuvre un filtre de longueur finie en émission/réception multiple permettant de satisfaire exactement à la contrainte de minimum de phase précitée.

Toutefois, un processus de traitement consistant en une généralisation de l'algorithme de Viterbi à contrainte réduite, connu sous le nom de algorithme GVA, a été proposé. L'idée de base du processus de traitement GVA précité consiste à compenser la dégradation de performances introduite par le traitement PSP précédemment cité en retenant un nombre $\Omega$ de trajets survivants supérieur à 1 par sous-état. Ce processus de traitement est ici désigné par GPSP, pour *Generalized Per Survivor Processing* en langage anglo-saxon. Lorsqu'un tel algorithme est appliqué à un processus d'égalisation et de décodage conjoint, l'algorithme de Viterbi généralisé GVA se révèle être très robuste au phénomène de propagation d'erreurs, ainsi que décrit par R. VISOZ, P. TORTELIER et A.O. BERTHET dans l'article publié par IEEE Electronic Letters, Vol.36, N°3, pp. 227-228, février 2000, précédemment cité dans la description.

En particulier, le processus de traitement GPSP précité rend la mise en oeuvre d'un préfiltrage à minimum de phase superflu.

Compte tenu de ces considérations générales, le module 210$_b$ d'égalisation et de détection conjointe peut être mis en oeuvre sous la forme d'un module logiciel basé sur des algorithmes d'égalisation et de décodage conjoint de type SISO spécialement adaptés pour réaliser une égalisation et un décodage conjoint multicouche, lesquels sont sensiblement améliorés grâce à l'utilisation du traitement GPSP.

Parmi les différents algorithmes d'égalisation et de décodage conjoint de type SISO susceptibles d'être utilisés pour la mise en oeuvre du module 210$_b$ précité, on peut citer l'algorithme SISO de détection multicouche optimal et de décodage spatio-temporel, l'algorithme de type BCJR à état réduit généralisé à récursion avant et arrière et, enfin, dans un mode de réalisation préférentiel qui sera seul décrit dans la présente description ci-après, l'algorithme de type SOVA à état réduit généralisé à une seule voie de récursion.

La mise en oeuvre de l'algorithme de type SOVA à état réduit généralisé à une seule voie de récursion précédemment mentionné permet une réduction significative, tant en terme de complexité calculatoire et d'espace mémoire nécessaire, par la suppression de la récursion arrière et traitement des sorties souples, c'est-à-dire des variables ou valeurs logarithmiques de rapport de probabilité a priori pendant la récursion avant, ainsi que proposé dans le cadre de l'algorithme SOVA par J.HAGENAUER, P. HOEHER dans l'article intitulé "*A Viterbi Algorithm with Soft Decision Outputs and its Applications*", publié par Proc., IEEE, Globecom, 89, pp.1680-1686, Dallas, USA, Nov.1989.

Pour la mise en oeuvre de l'algorithme de type SOVA à état réduit généralisé précité, dans le cadre du procédé et du système de décodage objets de la présente invention, on suppose que, à chaque section de temps discret $n-1$ et à chaque sous-état de départ $\boldsymbol{s'} \in \boldsymbol{V}_{n-1}^{\otimes}$ sont disponibles les quantités ou entités ci-après :

- une liste ordonnée $\mathbf{L_1} = \left\{ \overrightarrow{\mu}_{n-1}, \overset{s'}{\omega}, \omega \in [1, \Omega] \right\}$ de $\Omega$ métriques de sous-états accumulés par récursion avant ;

- une liste ordonnée $\mathbf{L_2}$ $\left\{ \underline{\hat{u}}_{k=n-\theta-1}^{n-1} \overset{s'}{\omega}, \omega \in [1, \Omega] \right\}$ des $\Omega$ trajets survivants correspondants, définis par

$\mathsf{L}_3$ : $\underline{\hat{u}}_{k=n-\theta-1}^{n-1} \overset{s'}{\omega} = \left\{ \underline{\hat{u}}_{n-\theta-1} \overset{s'}{\omega}, \underline{\hat{u}}_{n-\theta} \overset{s'}{\omega}, \cdots, \underline{\hat{u}}_{n-1} \overset{s'}{\theta} \right\}$ et terminant en s' ;

- une liste ordonnée $\mathbf{L_4}$ : $\left\{ \underline{\hat{\mathcal{L}}}_{k=n-\theta-1}^{n-1} \overset{s'}{\omega}, \omega \in [1, \Omega] \right\}$ des $\Omega$ valeurs pondérées non signées relatives à chaque bit définies par $\mathbf{L_5}$ : $\underline{\hat{\mathcal{L}}}_{k=n-\theta-1}^{n-1} \overset{s'}{\omega} = \left\{ \underline{\hat{\mathcal{L}}}_{n-\theta-1} \overset{s'}{\omega}, \underline{\hat{\mathcal{L}}}_{n-\theta} \overset{s'}{\omega}, \cdots, \underline{\hat{\mathcal{L}}}_{n-1} \overset{s'}{\theta} \right\}$ et terminant en s'.

Le module 210$_b$ d'égalisation et de décodage conjoint SISO mettant en oeuvre l'algorithme de type SOVA à état réduit généralisé à une voie de récursion réalise alors uniquement une récursion avant et à chaque section $n \in [1, \tau]$, pour chaque sous-état de terminaison $\boldsymbol{s} \in \boldsymbol{V}_n^{\otimes}$, calcule pour chaque transition $b \in B_n^{\otimes}$ tel que $b^+ = s$ et pour tous les rangs $\ell \leq \Omega$, les $\Omega \times \prod_{m=1}^{\nu} 2^{\kappa_m}$ entités suivantes, ces entités vérifiant la relation (20) :

$$\mu_{\bar{n},*}(s) = \mu_{\bar{n}-1,\ell}(b^-) + \xi_{n,\ell}(b) \qquad\qquad (20)$$

avec

$$\xi_{n,\ell}(b) = \frac{1}{2\sigma^2} \sum_{r=1}^{\rho} \left\| y_n^r - \sum_{m=1}^{\nu} \sum_{t=1}^{\eta_m} \sum_{k=0}^{\chi_c-1} z_{n-k}^{m,t} h_k^{m,t,r} \right\|^2 - \ell_n \Pr(b)$$

où $\xi_{n,\ell}(b)$ désigne la métrique de branche associée à la branche b, Pr(b) désigne la probabilité a priori sur la branche b, $\ell_n$ désignant le logarithme Népérien.

Les entités vérifiant la relation (20) précitée sont alors classées par ordre de valeur croissante.

La récursion avant est alors mise en oeuvre en tenant compte des conditions aux limites selon la relation (21) :

$$\mu_{\bar{0},1}(0) = 0 \quad \mu_{\bar{0},\omega}(0) = \infty \qquad \text{pour } \omega > 1 \tag{21}$$

et

$$\mu_{\bar{0},\omega}(s) = \infty, \forall s \neq 0, \omega \in [1,\Omega]$$

Seules les $\Omega$ meilleures valeurs des entités précitées sont alors mémorisées aux sous-états s pour le passage à la section suivante.

Simultanément, les trajets passés survivants vérifiant la relation :

$$\hat{\underline{u}}_{k=n-\theta-1}^{n-1} \genfrac{}{}{0pt}{}{s'}{\omega} , \omega \in [1,\Omega]$$

sont étendus selon les transitions existantes s': $\underline{u}_n \to s$. Les $\Omega \times \prod_{m=1}^{m=\nu} 2^{\kappa_m}$ nouveaux trajets survivants potentiels,

notés $\hat{\underline{u}}_{k=n-\theta}^{n} \genfrac{}{}{0pt}{}{s'}{*}$ sont temporairement mémorisés et triés compte tenu du rang de leur métrique associée $\mu_{\bar{n},*}(s)$

mais seuls les $\Omega$ meilleurs trajets, au sens des métriques qui leur sont associées, sont effectivement utilisés pour l'étape relative à la prochaine section.

De manière similaire, des valeurs passées non signées pondérées au niveau bit, notées :

$$\hat{\underline{L}}_{k=n-\theta-1}^{n-1} \genfrac{}{}{0pt}{}{s'}{\omega} , \omega \in [1,\Omega]$$

sont étendues conformément aux transitions existantes s' : $\underline{u}_n \to s$. Les $\Omega \times \prod_{m=1}^{m=\nu} 2^{\kappa_m}$ nouvelles séquences de valeurs pondérées non signées potentielles, notées $\hat{\underline{L}}_{k=n-\theta}^{n} \genfrac{}{}{0pt}{}{s}{*}$ sont temporairement mémorisées et triées selon le

rang des métriques $\mu_{\overrightarrow{n},*}(s)$. Pour chaque couche $m \in [1, \nu]$ et pour chaque bit d'entrée $j \in [1, \kappa_m]$, les valeurs

pondérées non signées estimées $\hat{L}_{n,m,j} \genfrac{}{}{0pt}{}{s}{\omega}$ sont initialisées selon la relation (22):

$$\hat{L}_{n,m,j}\ {}^{s}_{\omega} = \infty \qquad\qquad (22)$$

De même, seules les $\Omega$ meilleures séquences de valeurs pondérées non signées nécessitent d'être mémorisées pour l'étape relative à la section suivante.

Le module $210_b$ d'égalisation et de décodage conjoint procède ensuite à la mise à jour, par choix des valeurs pondérées, de l'algorithme de type SOVA.

Pour chaque sous-état $s \in V_n^{\otimes}$ , pour chaque couche $m \in [1,\nu]$, pour chaque bit d'entrée $j \in [1,\kappa_m]$ et pour chaque rang de survivant $\omega \in [1,\Omega]$, les séquences de valeur pondérée non signée au niveau bit sont mises à jour à partir de la profondeur $k = n-1$ jusqu'à la profondeur $k = n-\delta$ selon la relation (23):

$$\hat{L}_{\kappa,m,j}\ {}^{s}_{\omega} = f\!\left(\hat{L}_{\kappa,m,j}\ {}^{s}_{\omega}, \Delta_{n,m,j}\ {}^{s}_{\omega}\right) \qquad\qquad (23)$$

Dans les relations précédentes, on indique que $\omega$ désigne le rang de classement des métriques en un noeud, $\theta$ désigne la profondeur de délai de calcul et $\delta$ la profondeur de remise à jour des sorties souples, ou sorties pondérées. De manière générale, on indique que $\delta = \theta$.

Dans la relation (23) on indique en outre que $f(.)$ est une fonction d'adaptation ou de mise à jour et que $\Delta_{n,m,j}\ {}^{s}_{\omega}$ vérifie la relation (24) :

$$\Delta_{n,m,j}\ {}^{s}_{\omega} = \mu_{n,\overline{\omega}_{m,j}}^{\rightarrow}(s) - \mu_{n,\omega}^{\rightarrow}(s) \qquad\qquad (24)$$

Dans la relation (24) précitée $\overline{\omega}_{m,j}$ vérifie la relation (25) :

$$\overline{\omega}_{m,j} = \min\!\left\{\ell \geq \Omega+1, \hat{u}_{k,m,j}\ {}^{s}_{\ell} \neq \hat{u}_{k,m,j}\ {}^{s}_{\omega}\right\} \qquad\qquad (25)$$

La fonction de mise à jour $f(.)$ précédemment mentionnée dans la relation (23) peut être définie par la relation (26):

$$f\!\left(\hat{L}_{k,m,j}\ {}^{s}_{\omega}, \Delta_{n,m,j}\ {}^{s}_{\omega}\right) = \ln\frac{1+\exp\!\left(\hat{L}_{k,m,j}\ {}^{s}_{\omega} + \Delta_{n,m,j}\ {}^{s}_{\omega}\right)}{\exp\!\left(\hat{L}_{k,m,j}\ {}^{s}_{\omega}\right) + \exp\!\left(\Delta_{n,m,j}\ {}^{s}_{\omega}\right)} \qquad (26)$$

et peut, de manière habituelle, être calculée selon une valeur approchée par la relation (27) :

$$f\!\left(\hat{L}_{k,m,j}\ {}^{s}_{\omega}, \Delta_{n,m,j}\ {}^{s}_{\omega}\right) \approx \min\!\left\{\hat{L}_{k,m,j}\ {}^{s}_{\omega}, \Delta_{n,m,j}\ {}^{s}_{\omega}\right\} \qquad (27)$$

Lorsque $n \geq \theta$, l'algorithme de type SOVA généralisé délivre alors des décisions pondérées signées au niveau bit sur $\underline{u}_{n-\theta}$. Les valeurs pondérées signées au niveau bit vérifient la relation (28) :

$$\lambda\!\left(u^{m}_{n-\theta j}\right)=\left(2\times \hat{u}_{n-\theta,m,j}{}^{s*}_{1}-1\right)\times \hat{L}_{n-\theta,m,n}{}^{s*}_{1} \qquad (28)$$

et sont calculées pour $m \in [1,\nu]$ , $j \in [1,\kappa_m]$ en utilisant le trajet survivant de premier rang et la séquence de valeurs pondérées non signées au niveau bit correspondant, lesquelles se terminent chacune à la section n dans le sous-état s* défini par la relation (29) :

$$s^{*}=\arg\min\left\{\overrightarrow{\mu_{n,l}}(s)\,,s \in V^{\otimes}_{n}\right\} \qquad (29)$$

En définitive, la valeur logarithmique des rapports de probabilité extrinsèque utilisable sur les bits $u^{m}_{n-\theta,j}$ est calculée par soustraction bit à bit de la valeur logarithmique rapport de probabilité a priori $\lambda^{a}$ $u_{n-\theta,m,j)}$ provenant du décodage externe $C^{0}$, afin de produire les valeurs pondérées signées vérifiant la relation (30) :

$$\lambda^{e}\!\left(u^{m}_{n-\theta,j}\right)=\lambda\!\left(u^{m}_{n-\theta,j}\right)-\lambda^{a}\!\left(u^{m}_{n-\theta,j}\right) \qquad (30)$$

En référence à la figure 4, on indique que les valeurs logarithmiques des rapports de probabilité extrinsèque sur les bits $u^{m}_{n-\theta,j}$ constituent les flux d'information extrinsèque sur les bits des trames utilisateur $\left\{EIEUSO_{m}\right\}^{m=\nu}_{m=1}$ et que la valeur logarithmique des rapports de probabilité a priori, exprimée sous la forme $\lambda^{a}$ $(u_{n-\theta,m,j})$ constitue l'information a priori sur les bits des trames utilisateur $\left\{APIUDS_{m}\right\}^{m=\nu}_{m=1}$.

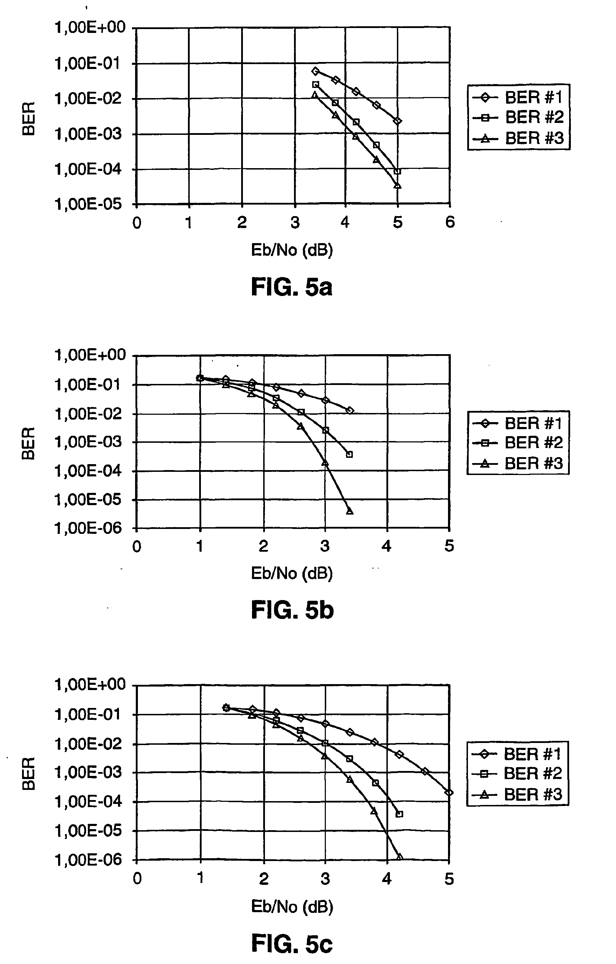

Différents résultats de simulation seront maintenant donnés en liaison avec les figures 5a, 5b et 5c, ces résultats de simulation consistant en des graphes représentatifs du taux d'erreur bit, noté BER, en fonction de la valeur du rapport signal à bruit $Eb/N_0$, exprimé en dB, pour un même signal numérique d'origine codé conformément au procédé objet de la présente invention, puis transmis et décodé conformément au même procédé objet de la présente invention, lorsque ce dernier est mis en oeuvre au moyen d'un processus d'égalisation et de décodage conjoint de type SOVA, pour différentes configurations de paramétrage du processus précité.

Sur la figure 5a, on a représenté le taux d'erreur bit BER pour une première, une deuxième et une troisième itération, notées #1, #2 et #3, pour un canal de transmission normalisé sévère, de type EQ-3 et pour une efficacité spectrale sensiblement constante de l'ensemble du système égale à 3 bits/s/Hz. Le nombre d'antennes d'émission était égal à 4 et le nombre d'antennes de réception égal à 2.

Le code externe utilisé $C^{0}$ était un code convolutif récursif systématique à huit états de rendement 3/4 et le code interne $\Xi^{m}$ identique pour chaque couche étant pour chaque couche un code non récursif non systématique de rendement 1/2 à quatre états, mis en correspondance *(mapped)* sur une constellation de type QPSK et produisant une ST-TCM triviale.
Dans ces conditions, le rendement global du codage est égal à 3/8.

Le nombre de salves est pris égal à n=8 par trame, et chaque salve contient 128 symboles QSPK.

Le processus de détection égalisation conjointe, de type SOVA, est mis en oeuvre pour une variable de remontée $\theta = 15$, une variable de profondeur de renouvellement $\delta = 15$ et un nombre de trajets survivants $\Omega = 8$. Il est appliqué sur un treillis interne réduit à 16 états.

On constate, pour un taux d'erreur bit de départ donné, voisin de $1{,}00\times10^{-1}$ à la première itération, une réduction de l'ordre de 1 dB entre la première et la deuxième itération, pour un taux d'erreur bit, égale $1{,}00\times10^{-2}$.

Sur la figure 5b, on a représenté le taux d'erreur bit BER pour une première, une deuxième et une troisième itération, notées #1, #2 et #3, pour un canal de transmission normalisé sévère, de type EQ-3 et pour une efficacité spectrale sensiblement constante de l'ensemble du système égale 2 bits/s/Hz. Le nombre d'antennes d'émission était égal à 3 et le nombre d'antennes de réception égal à 2.

Le code externe utilisé $C^0$ était un code convolutif récursif systématique à huit états de rendement 2/3 et le code interne $\Xi^m$ identique pour chaque cuche étant un code non récursif non systématique de rendement 1/2 à 4 états mis en correspondance (*mapped*) sur une constellation de type QSPK et produisant une ST-TCM triviale.

Dans ces conditions, le rendement global du codage est égal à 1/3.

Le nombre de salves est pris égal à n=8 par trame et chaque salve contient 128 symboles QSPK.

Le processus de détection égalisation conjointe de type SOVA est mis en oeuvre pour une variable de remontée $\theta = 15$, une variable de profondeur de renouvellement $\delta = 15$ et un nombre de trajets survivants $\Omega = 8$. Il est appliqué sur un treillis interne réduit à 16 états.

Sur la figure 5b, on peut constater, pour un taux d'erreur bit sensiblement égal à $1,00 \times 10^{-2}$, un gain en rapport signal à bruit de l'ordre de 1 dB entre la première et la troisième itération #1, #3.

Enfin, sur la figure 5c, on a représenté des conditions de simulation semblables à celles de la figure 5b, dans lesquelles toutefois le nombre de trajets survivants mis en oeuvre pour le processus d'égalisation et de détection conjointe de type SOVA, comprenait un nombre de trajets survivants $\Omega = 6$.

Alors que la décroissance du taux d'erreur bit BER en fonction du rapport signal à bruit $Eb/N_0$ exprimé en dB apparaît plus faible que dans le cas de la figure 5b, le gain en rapport signal à bruit $Eb/N_0$, pour un taux d'erreur bit BER $= 1,00 \times 10^{-3}$ entre la première et la troisième itération #1, #3, est proche de 1,5 dB.

**Revendications**

1.  Procédé de codage d'un flux de données numériques codées par combinaisons spatio-temporelles en émission et en réception multiple, **caractérisé en ce qu'**il consiste, à partir d'un flux initial de données numériques :

    - à soumettre ledit flux initial de données numériques à un codage externe (A) au moyen d'un premier code de rendement déterminé, pour engendrer un flux numérique codé ;
    - à soumettre ledit flux numérique codé, subdivisé en blocs successifs, à un processus d'entrelacement par blocs (B) pour engendrer un flux numérique codé;
    - à soumettre, ledit flux numérique codé et entrelacé à un démultiplexage (C), ledit flux numérique codé et entrelacé étant ainsi subdivisé en un nombre $\nu$ de flux numériques codés entrelacés élémentaires;
    - à soumettre chaque flux, numérique codé entrelacé élémentaire à un codage interne (D) au moyen d'au moins un deuxième code de rendement déterminé pour engendrer un ensemble de flux numériques élémentaires, codés par combinaisons spatio-temporelles :
    - à transmettre chaque flux numérique élémentaire constitué en symboles sur un canal de transmission (E) au moyen d'une antenne d'émission distincte, l'ensemble desdites antennes d'émission formant un réseau à diversité spatiale, pour engendrer un ensemble de flux numériques élémentaires transmis présentant une diversité spatiale et temporelle.

2.  Procédé selon la revendication 1, **caractérisé en ce que** ledit au moins un deuxième code permettant d'assurer ledit codage interne (D) est un code unique de rendement déterminé, appliqué à chaque flux numérique codé entrelacé élémentaire.

3.  Procédé selon la revendication 1, **caractérisé en ce que** ledit au moins un deuxième code permettant d'assurer ledit codage interne (D) est un code distinct de rendement déterminé, appliqué à l'un des flux numériques codés entrelacés élémentaires.

4.  Procédé selon l'une des revendications 1 à 3, **caractérisé en ce que** ledit au moins un deuxième code permettant d'assurer ledit codage interne (D) est constitué par un code du type modulation codée en treillis spatio-temporelle, chaque code étant appliqué à chaque flux numérique codé entrelacé élémentaire pour engendrer une pluralité de flux de symboles de modulation, chaque flux de symboles de modulation transmis sur le canal de transmission étant issu d'une antenne d'émission distincte, les groupes d'antennes d'émission distinctes de chaque code du type modulation, codée en treillis spatio-temporelle formant un sous-réseau d'antennes à diversité spatiale.

5.  Procédé de décodage d'un flux de données numériques codées par combinaisons spatio-temporelles en émission et en réception multiple, ce flux de données numériques codées consistant au moins en un ensemble de flux numériques élémentaires obtenus par un premier codage externe d'un flux initial de données numériques au moyen d'un premier code de rendement déterminé, entrelacement par blocs de flux numérique codé issu de ce premier codage externe, démultiplexage temporel du flux numérique codé et entrelacé obtenu sur un nombre déterminé $\nu$ de voies de démultiplexage, ce flux numérique codé et entrelacé étant ainsi subdivisé en un même nombre $\nu$ de

flux numériques codés et entrelacés élémentaires, soumission de chaque flux numérique codé et entrelacé élémentaire à un deuxième codage interne au moyen d'au moins un deuxième code de rendement déterminé pour engendrer ledit ensemble de flux numériques élémentaires, codés par combinaisons spatio-temporelles, transmission de chaque flux numérique élémentaire constitué en symboles au moyen d'une antenne d'émission distincte, l'ensemble des antennes d'émission formant un réseau d'antennes d'émission à diversité spatiale, **caractérisé en ce que** ledit procédé de décodage consiste:

- à recevoir (F) ledit flux de données numériques codées par combinaisons spatio-temporelles constitué par ledit ensemble de flux numériques élémentaires transmis sur un canal de transmission sur une pluralité d'antennes de réception, lesdites antennes de réception étant en nombre indépendant du nombre ν d'antennes d'émission et formant un réseau d'antennes de réception à diversité spatiale pour définir un ensemble de flux élémentaires de symboles de modulation reçus ;

- à soumettre ledit ensemble de flux élémentaires de symboles de modulation reçus à un processus itératif d'égalisation du canal de transmission et de décodage conjoint (G), au moyen dudit deuxième codage interne à partir d'un flux d'information extrinsèque sur les bits codés par le premier code externe et entrelacés issu d'un décodage à partir dudit code externe, ledit flux d'information extrinsèque sur les bits codés par le premier code externe et entrelacés constituant une information a priori, pour engendrer un premier flux d'information extrinsèque sur les bits codés par le premier code externe et entrelacés ;

- à soumettre ledit premier flux d'information extrinsèque à un désentrelacement (H), pour engendrer un deuxième flux d'information extrinsèque sur les bits codés en provenance du processus d'égalisation et de décodage conjoint ;

- à soumettre ledit deuxième flux d'information extrinsèque sur les bits codés à un décodage (I) à partir dudit premier code externe, pour engendrer un troisième flux d'information extrinsèque sur les bits codés, issu du décodage à partir dudit premier code externe ;

- à soumettre ledit troisième flux d'information extrinsèque à un entrelacement (J), pour engendrer ledit flux d'information extrinsèque sur les bits codés par le premier code externe et entrelacés, constituant ladite information a priori ;

- à réinjecter (K) ladite information a priori dans le processus itératif d'égalisation du canal de transmission et de décodage conjoint.

6. Procédé selon la revendication 5, **caractérisé en ce que**, pour un deuxième codage interne du type modulation codée en treillis spatio-temporelle, ledit processus itératif d'égalisation et de décodage conjoint consiste:

- à démultiplexer (G1) ledit flux d'information extrinsèque sur les bits codés par le premier code externe et entrelacés, constituant ladite information a priori, en un ensemble de flux d'information a priori sur les bits de trames utilisateur subdivisées en paquets ;

- à effectuer une égalisation et un décodage conjoint (G2) à entrée/sortie souple appliqués à un treillis réduit en nombre d'états, ce treillis étant défini comme le produit des treillis combinés des modulations codées en treillis spatio-temporelles et des canaux à mémoire élémentaire s'y rapportant, eux-mêmes réduits en nombre d'états, pour engendrer un flux de sorties pondérées sur les bits des trames utilisateur ;

- à extraire (G3) de chaque flux de sorties pondérées sur les bits des trames utilisateur ladite information a priori sur les bits des trames utilisateur, pour engendrer un flux d'information extrinsèque sur les bits des trames utilisateur ;

- à multiplexer (G4) les flux d'information extrinsèque sur les bits des trames utilisateur, pour engendrer ledit premier flux d'information extrinsèque sur les bits codés par le premier code externe et entrelacés.

7. Procédé selon la revendication 5 ou 6, **caractérisé en ce que** ledit décodage au moyen dudit premier code externe consiste :

- à soumettre ledit deuxième flux d'information extrinsèque sur les bits codés en provenance du processus d'égalisation et de décodage conjoint à un décodage (I1) à entrée/sortie pondérée au moyen dudit premier code externe, pour engendrer un flux de sorties pondérées représentatives d'une information a posteriori sur les bits codés ;

- à soustraire (12) ledit deuxième flux d'information extrinsèque dudit flux de sorties pondérées représentatives de ladite information a posteriori sur les bits codés, pour engendrer ledit troisième flux d'information extrinsèque sur les bits codés.

8. Système de codage d'un flux de données numériques codées par combinaisons spatio-temporelles en émission et en réception multiple, ce système comportant au moins:

- des moyens de codage externe (10) d'un flux initial de données numériques (IDS), à partir d'un premier code de rendement déterminé, pour engendrer un flux numérique codé, subdivisé en blocs successifs ;
- des moyens d'entrelacement par blocs (11) permettant, à partir dudit flux numérique codé, d'engendrer un flux numérique codé entrelacé présentant une diversité temporelle ;
- des moyens démultiplexeurs (12) recevant ledit flux numérique codé entrelacé, permettant d'engendrer un nombre $\nu$ de flux numériques codés entrelacés élémentaires ;
- une pluralité de moyens de codage interne (13m) à partir d'au moins un deuxième code de rendement déterminé, chaque moyen de codage interne recevant l'un desdits flux numériques codés entrelacés élémentaires, pour engendrer un ensemble de flux numériques élémentaires, codés par combinaisons spatio-temporelles et constitués en symboles ;
- une pluralité d'antennes d'émission ($ta_m$) de chaque flux numérique élémentaire codé par combinaison spatio-temporelle et constitué en symboles, une antenne d'émission distincte assurant la transmission d'un flux numérique élémentaire, l'ensemble desdites antennes d'émission formant un réseau à diversité spatiale, ledit système permettant d'engendrer un ensemble de flux numériques élémentaires transmis présentant une diversité spatiale et temporelle.

9. Système de codage selon la revendication 8, **caractérisé en ce que**, pour un deuxième code permettant d'assurer ledit codage interne constitué par un codé du type modulation codée en treillis spatio-temporelle, chaque code étant appliqué à chaque flux numérique codé entrelacé élémentaire, pour engendrer une pluralité de flux de symboles de modulation, les antennes d'émission distinctes sont arrangées en groupes d'antennes transmettant chacun un flux de symboles de modulation, les groupes d'antennes d'émission distinctes de chaque type de modulation codée en treillis- spatio-temporelle formant un sous-réseau d'antennes à diversité spatiale.

10. Système de décodage d'un flux de données numériques codées par combinaison spatio-temporelle en émission et en réception multiple, ce flux de données numériques codées consistant au moins en un ensemble de flux numériques élémentaires transmis obtenu par un premier codage externe d'un flux initial de données numériques au moyen d'un premier code de rendement déterminé, entrelacement par blocs du flux numérique codé issu de ce premier codage externe, démultiplexage temporel du flux numérique codé et entrelacé obtenu sur un nombre déterminé $\nu$ de voies de démultiplexage, ce flux numérique codé et entrelacé étant ainsi subdivisé en un même nombre $\nu$ de flux numériques codés et entrelacés élémentaires, soumission de chaque flux numérique codé et entrelacé élémentaire à un deuxième codage interne au moyen d'au moins un deuxième code de rendement déterminé, pour engendrer cet ensemble de flux numériques élémentaires, codés par combinaisons spatio-temporelles, transmission de chaque flux numérique élémentaire subdivisé en symboles au moyen d'une antenne d'émission distincte selon un ensemble de flux élémentaires transmis sur un canal de transmission, l'ensemble des antennes d'émission formant un réseau d'antennes d'émission à diversité spatiale, ce système de décodage comprenant :

- une pluralité d'antennes de réception ($ra_r$) permettant de recevoir ledit ensemble de flux numériques élémentaires transmis sur ce canal de transmission, lesdites antennes dé réception étant en nombre indépendant du nombre $\nu$ d'antennes d'émission et formant un réseau d'antennes de réception à diversité spatiale, pour définir un ensemble de flux élémentaires de symboles de modulation reçus;
- des moyens de turbo-détection desdits flux élémentaires de symboles de modulation reçus par égalisation et détection conjointe et décodage itératifs, lesdits moyens de turbo-détection comportant :

   ■ des moyens d'égalisation (210) du canal de transmission et de décodage conjoint, au moyen dudit deuxième codage interne à partir d'un flux d'information extrinsèque sur les bits codés par le premier code externe et entrelacés issu d'un décodage à partir dudit code externe, ledit flux d'information extrinsèque sur les bits codés par le premier code externe et entrelacés constituant une information a priori, lesdits moyens d'égalisation du canal de transmission et de décodage conjoint permettant, à partir desdits flux élémentaires de symboles de modulation reçus, d'engendrer un premier flux d'information extrinsèque sur les bits codés par le premier code externe et entrelacés ;
   ■ des moyens de désentrelacement (211) dudit premier flux d'information extrinsèque, pour engendrer un deuxième flux d'information extrinsèque sur les bits codés en provenance des moyens d'égalisation et de décodage conjoint ;
   ■ des moyens de décodage (212) à partir dudit premier code externe recevant ledit deuxième flux d'information extrinsèque et permettant d'engendrer un troisième flux d'information extrinsèque sur les bits codés, issu du décodage à partir dudit premier code externe ;

■ des moyens d'entrelacement (213) dudit troisième flux d'information extrinsèque, pour engendrer ledit flux d'information extrinsèque sur les bits codés par le premier code externe et entrelacés, constituant ladite information a priori réinjectée dans lesdits moyens d'égalisation du canal de transmission et de décodage conjoint.

**11.** Système selon la revendication 10, **caractérisé en ce que** lesdits moyens d'égalisation et de décodage conjoint comportent:

- un module d'injection (210a) de ladite information à priori comprenant des moyens démultiplexéurs recevant ladite information a priori constituée par ledit flux d'information extrinsèque sur les bits codés par le premier code externe et entrelacés et délivrant un ensemble de flux d'information a priori sur les bits de trames utilisateur, ledit ensemble de flux étant démultiplexé sur un même nombre v de voies de démultiplexage que le nombre de flux numériques codés et entrelacés élémentaires engendrés à l'émission;
- des moyens de décodage (210b) à entrée/sortie pondérée recevant en entrée, d'une part, ledit flux d'information a priori sur les bits de trames utilisateur, et, d'autre part, lesdits flux élémentaires de symboles de modulation reçus et délivrant un flux de sorties pondérées sur les bits des trames utilisateur ;
- une pluralité de moyens soustracteurs (210c), permettant de soustraire de chaque flux de sorties pondérées sur les bits des trames utilisateur ladite information a priori sur les bits de trames utilisateur et délivrant un flux d'information extrinsèque sur les bits des trames utilisateur ;
- des moyens multiplexeurs (210d) des flux d'information extrinsèque permettant, à partir dudit flux d'information extrinsèque sur les bits des trames utilisateur, de délivrer ledit premier flux d'information extrinsèque sur les bits codés par le premier code et entrelacés.

**12.** Système selon la revendication 10 ou 11, **caractérisé en ce que** lesdits moyens de décodage à partir dudit premier code externe comprennent :

- un module de décodage (212a) à entrée/sortie pondérée recevant ledit deuxième flux d'information extrinsèque sur les bits codés en provenance du processus d'égalisation et de décodage conjoint et délivrant un flux de sorties pondérées représentatives d'une information a posteriori sur les bits codés ;
- un module soustracteur (212b) permettant de soustraire dudit flux de sorties pondérées représentatives d'une information a posteriori sur les bits, codés ledit deuxième flux d'information extrinsèque et délivrant ledit troisième flux d'information extrinsèque sur les bits codés, issu du décodage à partir dudit premier code externe.

**Claims**

**1.** Method of coding a digital data stream coded by spatio-temporal combinations in multiple transmission and reception, **characterized in that** it consists, on the basis of an initial digital data stream:

- in subjecting the said initial digital data stream to an outer coding (A) by means of a first code of specified rate, so as to generate a coded digital stream;
- in subjecting the said coded digital stream, subdivided into successive blocks, to a blockwise interleaving process (B) so as to generate a coded digital stream;
- in subjecting the said coded and interleaved digital stream to a demultiplexing (C), the said coded and interleaved digital stream being thus subdivided into a number v of elementary interleaved coded digital streams;
- in subjecting each elementary interleaved coded digital stream to an inner coding (D) by means of at least one second code of specified rate so as to generate a set of elementary digital streams, coded by spatio-temporal combinations;
- in transmitting each elementary digital stream consisting of symbols over a transmission channel (E) by means of a distinct transmission antenna, the set of the said transmission antennas forming a space-diversity array, so as to generate a set of transmitted elementary digital streams exhibiting spatial and temporal diversity.

**2.** Method according to Claim 1, **characterized in that** the said at least one second code making it possible to achieve the said inner coding (D) is a unique code of specified rate, applied to each elementary interleaved coded digital stream.

**3.** Method according to Claim 1, **characterized in that** the said at least one second code making it possible to achieve the said inner coding (D) is a distinct code of specified rate, applied to one of the elementary interleaved coded digital streams.

4. Method according to one of Claims 1 to 3, **characterized in that** the said at least one second code making it possible to achieve the said inner coding (D) consists of a code of the spatio-temporal trellis coded modulation type, each code being applied to each elementary interleaved coded digital stream so as to generate a plurality of streams of modulation symbols, each stream of modulation symbols transmitted over the transmission channel emanating from a distinct transmission antenna, the groups of distinct transmission antennas for each code of the spatio-temporal trellis coded modulation type forming a sub-array of space-diversity antennas.

5. Method of decoding a digital data stream coded by spatio-temporal combinations in multiple transmission and reception, this coded digital data stream consisting at least of a set of elementary digital streams obtained by a first outer coding of an initial digital data stream by means of a first code of specified rate, blockwise interleaving of the coded digital stream emanating from this first outer coding, temporal demultiplexing of the coded and interleaved digital stream obtained on a specified number $\nu$ of demultiplexing pathways, this coded and interleaved digital stream being thus subdivided into one and the same number $\nu$ of elementary coded and interleaved digital streams, subjecting each elementary coded and interleaved digital stream to a second inner coding by means of at least one second code of specified rate so as to generate the said set of elementary digital streams, coded by spatio-temporal combinations, transmission of each elementary digital stream consisting of symbols by means of a distinct transmission antenna, the set of the transmission antennas forming an array of space-diversity transmission antennas, **characterized in that** the said decoding method consists:

- in receiving (F) the said digital data stream coded by spatio-temporal combinations and consisting of the said set of elementary digital streams transmitted over a transmission channel on a plurality of reception antennas, the number of the said reception antennas being independent of the number $\nu$ of transmission antennas and forming an array of space-diversity reception antennas so as to define a set of elementary streams of modulation symbols received;
- in subjecting the said set of elementary streams of modulation symbols received to an iterative process of equalization of the transmission channel and of joint decoding (G), by means of the said second inner coding on the basis of an extrinsic information stream on the bits coded by the first outer code and interleaved and emanating from a decoding on the basis of the said outer code, the said extrinsic information stream on the bits coded by the first outer code and interleaved constituting an a priori information item, so as to generate a first extrinsic information stream on the bits coded by the first outer code and interleaved;
- in subjecting the said first extrinsic information stream to a deinterleaving (H) so as to generate a second extrinsic information stream on the coded bits originating from the equalization and joint decoding process;
- in subjecting the said second extrinsic information stream on the coded bits to a decoding (I) on the basis of the said first outer code, so as to generate a third extrinsic information stream on the coded bits, and emanating from the decoding on the basis of the said first outer code;
- in subjecting the said third extrinsic information stream to an interleaving (J), so as to generate the said extrinsic information stream on the bits coded by the first outer code and interleaved, constituting the said a priori information item;
- in reinjecting (K) the said a priori information item into the iterative process for equalization of the transmission channel and joint decoding.

6. Method according to Claim 5, **characterized in that**, for a second inner coding of the spatio-temporal trellis coded modulation type, the said iterative process of equalization and joint decoding consists:

- in demultiplexing (G1) the said extrinsic information stream on the bits coded by the first outer code and interleaved, constituting the said a priori information item, as a set of a priori information streams on the bits of user frames subdivided into packets;
- in performing an equalization and a joint decoding (G2) with soft input/output which are applied to a trellis with a reduced number of states, this trellis being defined as the product of the combined trellises of the spatio-temporal trellis coded modulations and of the elementary-memory channels referring thereto, which themselves have a reduced number of states, so as to generate a stream of weighted outputs on the bits of the user frames;
- in extracting (G3) from each stream of weighted outputs on the bits of the user frames the said a priori information item on the bits of the user frames, so as to generate an extrinsic information stream on the bits of the user frames;
- in multiplexing (G4) the extrinsic information streams on the bits of the user frames, so as to generate the said first extrinsic information stream on the bits coded by the first outer code and interleaved.

7. Method according to Claim 5 or 6, **characterized in that** the said decoding by means of the said first outer code consists:

- in subjecting the said second extrinsic information stream on the coded bits originating from the equalization and joint decoding process to a decoding (I1) with weighted input/output by means of the said first outer code, so as to generate a stream of weighted outputs representative of an a posteriori information item on the coded bits;
- in subtracting (I2) the said second extrinsic information stream from the said stream of weighted outputs representative of the said a posteriori information item on the coded bits, so as to generate the said third extrinsic information stream on the coded bits.

8. System for coding a digital data stream coded by spatio-temporal combinations in multiple transmission and reception, this system comprising at least:

- means of outer coding (10) of an initial digital data stream (IDS), on the basis of a first code of specified rate, so as to generate a coded digital stream, subdivided into successive blocks;
- means of blockwise interleaving (11) making it possible, on the basis of the said coded digital stream, to generate an interleaved coded digital stream exhibiting temporal diversity;
- demultiplexer means (12) receiving the said interleaved coded digital stream, making it possible to generate a number $\nu$ of elementary interleaved coded digital streams;
- a plurality of means of inner coding (13m) on the basis of at least one second code of specified rate, each means of inner coding receiving one of the said elementary interleaved coded digital streams, so as to generate a set of elementary digital streams, coded by spatio-temporal combinations and consisting of symbols;
- a plurality of transmission antennas ($ta_m$) for each elementary digital stream coded by spatio-temporal combinations and consisting of symbols, a distinct transmission antenna achieving the transmission of an elementary digital stream, the set of the said transmission antennas forming a space-diversity array, the said system making it possible to generate a set of transmitted elementary digital streams exhibiting spatial and temporal diversity.

9. Coding system according to Claim 8, **characterized in that**, for a second code making it possible to achieve the said inner coding consisting of a code of the spatio-temporal trellis coded modulation type, each code being applied to each elementary interleaved coded digital stream, so as to generate a plurality of streams of modulation symbols, the distinct transmission antennas are arranged in groups of antennas each transmitting a stream of modulation symbols, the groups of distinct transmission antennas for each type of spatio-temporal trellis coded modulation forming a sub-array of space-diversity antennas.

10. System for decoding a digital data stream coded by spatio-temporal combination in multiple transmission and reception, this coded digital data stream consisting at least of a set of transmitted elementary digital streams obtained by a first outer coding of an initial digital data stream by means of a first code of specified rate, blockwise interleaving of the coded digital stream emanating from this first outer coding, temporal demultiplexing of the coded and interleaved digital stream obtained on a specified number $\nu$ of demultiplexing pathways, this coded and interleaved digital stream being thus subdivided into one and the same number $\nu$ of elementary coded and interleaved digital streams, subjecting each elementary coded and interleaved digital stream to a second inner coding by means of at least one second code of specified rate so as to generate this set of elementary digital streams, coded by spatio-temporal combinations, transmission of each elementary digital stream subdivided into symbols by means of a distinct transmission antenna according to a set of elementary streams transmitted over a transmission channel, the set of the transmission antennas forming an array of space-diversity transmission antennas, this decoding system comprising:

- a plurality of reception antennas ($ra_r$) making it possible to receive the said set of elementary digital streams transmitted over this transmission channel, the number of the said reception antennas being independent of the number $\nu$ of transmission antennas and forming an array of space-diversity reception antennas, so as to define a set of elementary streams of modulation symbols received;
- means of turbo-detection of the said elementary streams of modulation symbols received by iterative equalization and iterative joint detection and iterative decoding, the said turbo-detection means comprising:

■ means of equalization (210) of the transmission channel and of joint decoding, by means of the said second inner coding on the basis of an extrinsic information stream on the bits coded by the first outer code and interleaved and which arises from a decoding on the basis of the said outer code, the said extrinsic information stream on the said bits coded by the first outer code and interleaved constituting an a priori information item, the said means of equalization of the transmission channel and of joint decoding making it possible, on the basis of the said elementary streams of modulation symbols received, to generate a first extrinsic information stream on the bits coded by the first outer code and interleaved;

■ means of deinterleaving (211) the said first extrinsic information stream, so as to generate a second extrinsic information stream on the coded bits originating from the means of equalization and of joint decoding;

■ means of decoding (212) on the basis of the said first outer code receiving the said second extrinsic information stream and making it possible to generate a third extrinsic information stream on the coded bits, which arises from the decoding on the basis of the said first outer code;

■ means of interleaving (213) the said third extrinsic information stream, so as to generate the said extrinsic information stream on the bits coded by the first outer code and interleaved, constituting the said a priori information item reinjected into the said means of equalization of the transmission channel and of joint decoding.

**11.** System according to Claim 10, **characterized in that** the said means of equalization and of joint decoding comprise:

- a module for injecting (210a) the said a priori information item comprising demultiplexer means receiving the said a priori information item constituted by the said extrinsic information stream on the bits coded by the first outer code and interleaved and delivering a set of a priori information streams on the bits of user frames, the said set of streams being demultiplexed on one and the same number $\nu$ of demultiplexing pathways as the number of elementary coded and interleaved digital streams generated on transmission;
- means of decoding (210b) with weighted input/output receiving as input, on the one hand, the said a priori information stream on the bits of user frames, and, on the other hand, the said elementary streams of modulation symbols received and delivering a stream of weighted outputs on the bits of the user frames;
- a plurality of subtractor means (210c), making it possible to subtract from each stream of weighted outputs on the bits of the user frames, the said a priori information item on the bits of user frames and delivering an extrinsic information stream on the bits of the user frames;
- multiplexer means (210d) for multiplexing the extrinsic information streams making it possible, on the basis of the said extrinsic information stream on the bits of the user frames, to deliver the said first extrinsic information stream on the bits coded by the first code and interleaved.

**12.** System according to Claim 10 or 11, **characterized in that** the said means of decoding on the basis of the said first outer code comprise:

- a decoding module (212a) with weighted input/output receiving the said second extrinsic information stream on the coded bits originating from the equalization and joint decoding process and delivering a stream of weighted outputs representative of an a posteriori information item on the coded bits;
- a subtractor module (212b) making it possible to subtract from the said stream of weighted outputs representative of an a posteriori information item on the coded bits the said second extrinsic information stream and delivering the said third extrinsic information stream on the coded bits, which arises from the decoding on the basis of the said first outer code.

**Patentansprüche**

**1.** Verfahren zum Codieren eines durch raum-zeitliche Kombinationen codierten digitalen Datenstroms bei Mehrfachsendung und Mehrfachempfang, **dadurch gekennzeichnet, dass** es ausgehend von einem Anfangsstrom von digitalen Daten darin besteht:

- den Anfangsstrom von digitalen Daten mittels eines ersten bestimmten Leistungscodes einer externen Codierung (A) zu unterziehen, um einen codierten digitalen Datenstrom zu erzeugen;
- den codierten digitalen Datenstrom, unterteilt in aufeinander folgende Blöcke, einem blockweisen (B) Verschachtelungsprozess zu unterziehen, um einen codierten digitalen Datenstrom zu erzeugen;
- den codierten und verschachtelten digitalen Datenstrom einer Demultiplexierung (C) zu unterziehen, wobei der codierte und verschachtelte digitale Datenstrom so in eine Anzahl $\nu$ von elementaren verschachtelten codierten digitalen Datenströmen unterteilt wird;

- jeden elementaren verschachtelten codierten digitalen Datenstrom mittels mindestens eines zweiten bestimmten Leistungscodes einer internen Codierung (D) zu unterziehen, um eine Gruppe von durch raum-zeitliche Kombinationen elementaren codierten digitalen Datenströmen zu erzeugen;

- jeden aus Symbolen bestehenden elementaren digitalen Datenstrom auf einem Übertragungskanal (E) mittels einer eigenen Sendeantenne zu übertragen, wobei die Gesamtheit der Sendeantennen ein Netz mit Raum-Diversity bildet, um eine Gruppe von übertragenen elementaren digitalen Datenströmen zu erzeugen, die eine Raum- und Zeit-Diversity aufweisen.

**2.** Verfahren nach Anspruch 1, **dadurch gekennzeichnet, dass** der mindestens eine zweite Code, der es ermöglicht, die interne Codierung (D) zu gewährleisten, ein einziger Code einer bestimmten Leistung ist, der bei jedem elementaren verschachtelten codierten digitalen Datenstrom angewendet wird.

**3.** Verfahren nach Anspruch 1, **dadurch gekennzeichnet, dass** der mindestens eine zweite Code, der es ermöglicht, die interne Codierung (D) zu gewährleisten, ein unterschiedlicher bestimmter Leistungscode ist, der an einen der elementaren verschachtelten codierten digitalen Datenströme angewendet wird.

**4.** Verfahren nach einem der Ansprüche 1 bis 3, **dadurch gekennzeichnet, dass** der mindestens eine zweite Code, der es ermöglicht, die interne Codierung (D) zu gewährleisten, aus einem Code des Typs raum-zeitliche gittercodierte Modulation besteht, wobei jeder Code an jeden elementaren verschachtelten codierten digitalen Datenstrom angewendet wird, um mehrere Ströme von Modulationssymbolen zu erzeugen, wobei jeder Modulationssymbolstrom, der auf dem Übertragungskanal übertragen wird, von einer verschiedenen Sendeantenne stammt, wobei die Gruppen von verschiedenen Sendeantennen jedes Codes vom Typ raum-zeitliche gittercodierte Modulation ein Unternetz von Antennen mit Raum-Diversity bildet.

**5.** Verfahren zum Decodieren eines Stroms von durch raum-zeitliche Kombinationen codierten digitalen Daten bei Mehrfachsendung und Mehrfachempfang, wobei dieser Strom von codierten digitalen Daten aus mindestens einer Gruppe von elementaren digitalen Datenströmen besteht, die: erhalten werden durch eine erste externe Codierung eines anfänglichen digitalen Datenstroms mittels eines ersten Codes bestimmter Leistung, blockweise Verschachtelung eines von dieser ersten externen Codierung stammenden codierten digitalen Datenstroms, zeitliche Demultiplexierung des codierten und verschachtelten digitalen Datenstroms, die in einer bestimmten Anzahl ν von Demultiplexierkanälen erhalten wird, wobei dieser codierte und verschachtelte digitale Datenstrom so in eine gleiche Anzahl ν von elementaren codierten und verschachtelten digitalen Datenströmen aufgeteilt wird, Unterziehen jedes elementaren codierten und verschachtelten digitalen Datenstroms einer zweiten internen Codierung mittels mindestens eines zweiten Codes bestimmter Leistung, um die Gruppe von durch raum-zeitliche Kombinationen codierten elementaren digitalen Datenströmen zu erzeugen, Übertragung jedes aus Symbolen bestehenden elementaren digitalen Datenstroms mittels einer jeweils eigenen Sendeantenne, wobei die Gruppe der Sendeantennen ein Netz von Sendeantennen mit Raum-Diversity bildet, **dadurch gekennzeichnet, dass** das Decodierverfahren darin besteht:

- den durch raum-zeitliche Kombinationen codierten digitalen Datenstrom zu empfangen (F), der aus der Gruppe von elementaren digitalen Datenströmen gebildet wird, die über einen Übertragungskanal auf mehrere Empfangsantennen übertragen wird, wobei die Empfangsantennen in einer Anzahl unabhängig von der Anzahl ν der Sendantennen vorhanden sind und ein Netz von Empfangsantennen mit Raum-Diversity bilden, um eine Gruppe von elementaren Strömen von empfangenen Modulationssymbolen zu definieren;

- die Gruppe von elementaren Strömen von empfangenen Modulationssymbolen einem iterativen Prozess der Egalisierung des Übertragungskanals und der damit verbundenen Decodierung (G) mittels der zweiten internen Codierung ausgehend von einem extrinsischen Informationsstrom über die vom ersten externen Code codierten und verschachtelten Bits, der von einer Decodierung ausgehend von dem externen Code stammt, zu unterziehen, wobei der extrinsische Informationsstrom über die vom ersten externen Code codierten und verschachtelten Bits eine A-priori-Information bildet, um einen ersten extrinsischen Informationsstrom über die vom ersten externen Code codierten und verschachtelten Bits zu erzeugen;

- den ersten extrinsischen Informationsstrom einer Entschachtelung (H) zu unterziehen, um einen zweiten extrinsischen Informationsstrom über die codierten Bits zu erzeugen, die vom Prozess der Egalisierung und der damit verbundenen Decodierung stammen;

- den zweiten extrinsischen Informationsstrom über die codierten Bits einer Decodierung (I) ausgehend vom ersten externen Code zu unterziehen, um einen dritten extrinsischen Informationsstrom über die codierten Bits zu erzeugen, der von der Decodierung ausgehend vom ersten externen Code stammt;

- den dritten extrinsischen Informationsstrom einer Verschachtelung (J) zu unterziehen, um den extrinsischen Informationsstrom über die vom ersten externen Code codierten und verschachtelten Bits zu erzeugen, der die A-priori-Information bildet;
- die A-priori-Information (K) in den iterativen Prozess der Egalisierung des Übertragungskanals und der damit verbundenen Decodierung rückzuspeisen.

**6.** Verfahren nach Anspruch 5, **dadurch gekennzeichnet, dass** der iterative Prozess der Egalisierung und der damit verbundenen Decodierung für eine zweite interne Codierung vom Typ raum-zeitliche gittercodierte Modulation darin besteht:

- den extrinsischen Informationsstrom über die vom ersten externen Code codierten und verschachtelten Bits, der die A-priori-Information bildet, in eine Gruppe von A-priori-Informationsströmen über die Bits von Benutzerrahmen zu demultiplexieren (G1), die in Pakete unterteilt sind;
- eine Egalisierung und eine damit verbundene Decodierung (G2) mit flexiblem Eingang und Ausgang durchzuführen, die auf ein Gitter mit einer reduzierten Anzahl von Zuständen angewendet werden, wobei dieses Gitter als das Produkt der kombinierten Gitter der raumzeitlichen gitterkombinierten Modulationen und der dazugehörigen Kanäle mit Elementarspeicher definiert wird, deren Anzahl von Zuständen ebenfalls reduziert ist, um einen Strom von auf die Bits der Benutzerrahmen gewichteten Ausgangssignalen zu erzeugen;
- aus jedem Strom von auf die Bits der Benutzerrahmen gewichteten Ausgängen die A-priori-Information über die Bits der Benutzerrahmen zu entnehmen (G3), um einen extrinsischen Informationsstrom über die Bits der Benutzerrahmen zu erzeugen;
- die extrinsischen Informationsströme über die Bits der Benutzerrahmen zu multiplexieren (G4), um den ersten extrinsischen Informationsstrom über die vom ersten externen Code codierten und verschachtelten Bits erzeugen.

**7.** Verfahren nach Anspruch 5 oder 6, **dadurch gekennzeichnet, dass** die Decodierung mittels des ersten externen Codes darin besteht:

- den zweiten extrinsischen Informationsstrom über die vom Prozess der Egalisierung und der damit verbundenen Decodierung stammenden codierten Bits einer Decodierung (11) mit gewichtetem Eingang und Ausgang mit Hilfe des ersten externen Codes zu unterziehen, um einen Strom von gewichteten Ausgängen zu erzeugen, die für eine A-posteriori-Information über die codierten Bits repräsentativ sind;
- den zweiten extrinsischen Informationsstrom von dem Strom von gewichteten Ausgängen zu subtrahieren (I2), die für die A-posteriori-Information über die codierten Bits repräsentativ sind, um den dritten extrinsischen Informationsstrom über die codierten Bits zu erzeugen.

**8.** System zum Codieren eines Stroms von durch raum-zeitliche Kombinationen codierten digitalen Daten bei Mehrfachsendung und Mehrfachempfang, wobei dieses System mindestens aufweist:

- Mittel zur externen Codierung (10) eines Anfangsstroms von digitalen Daten (IDS) ausgehend von einem ersten bestimmten Leistungscode, um einen codierten digitalen Datenstrom zu erzeugen, der in aufeinander folgende Blöcke unterteilt ist;
- Mittel zur blockweisen Verschachtelung (11), die es ausgehend vom codierten digitalen Datenstrom ermöglichen, einen verschachtelten codierten digitalen Datenstrom zu erzeugen, der eine Zeit-Diversity aufweist;
- Demultiplexiermittel (12), die den verschachtelten codierten digitalen Datenstrom empfangen und es ermöglichen, eine Anzahl $\nu$ von elementaren verschachtelten codierten digitalen Datenströmen zu erzeugen;
- mehrere Mittel zur internen Codierung (13m) ausgehend von mindestens einem zweiten Code einer bestimmten Leistung, wobei jedes Mittel zur internen Codierung einen der elementaren verschachtelten codierten digitalen Datenströme empfängt, um eine Gruppe von elementaren digitalen Datenströmen zu erzeugen, die durch raum-zeitliche Kombinationen codiert sind und aus Symbolen bestehen;
- mehrere Sendeantennen ($ta_m$) jedes durch raum-zeitliche Kombination codierten und aus Symbolen bestehenden elementaren digitalen Datenstroms, wobei eine bestimmte Sendeantenne die Übertragung eines elementaren digitalen Datenstroms gewährleistet, wobei die Gesamtheit der Sendeantennen ein Netz mit Raum-Diversity bildet, wobei das System es ermöglicht, eine Gruppe von übertragenen elementaren digitalen Datenströmen zu erzeugen, die eine Raum- und Zeit-Diversity aufweisen.

**9.** Codiersystem nach Anspruch 8, **dadurch gekennzeichnet, dass** für einen zweiten Code, der es ermöglicht, die interne Codierung zu gewährleisten, die aus einem Code des Typs raum-zeitliche gittercodierte Modulation besteht, wobei jeder Code auf jeden elementaren verschachtelten codierten digitalen Datenstrom angewendet wird, um mehrere Ströme von Modulationssymbolen zu erzeugen, wobei die unterschiedlichen Sendeantennen in Gruppen von Antennen angeordnet sind, die je einen Strom von Modulationssymbolen übertragen, wobei die Gruppen von unterschiedlichen Sendeantennen jedes Typs von raum-zeitlicher gittercodierter Modulation ein Unternetz von Antennen mit Raum-Diversity bilden.

**10.** System zum Decodieren eines Stroms von durch raum-zeitliche Kombinationen codierten digitalen Daten bei Mehrfachsendung und Mehrfachempfang, wobei dieser Strom von codierten digitalen Daten mindestens aus einer Gruppe von übertragenen elementaren digitalen Datenströmen besteht, die erhalten wird durch eine erste externe Codierung eines Anfangsstroms von digitalen Daten mittels eines ersten bestimmten Leistungscodes, durch eine blockweise Verschachtelung des codierten digitalen Datenstroms, der von dieser ersten externen Codierung stammt, durch zeitliche Demultiplexierung des codierten und verschachtelten digitalen Datenstroms, der auf einer bestimmten Anzahl $\nu$ von Demultiplexierkanälen erhalten wird, wobei dieser codierte und verschachtelte digitale Datenstrom so in eine gleiche Anzahl $\nu$ von elementaren codierten und verschachtelten Datenströmen unterteilt wird, durch Unterziehen jedes elementaren codierten und verschachtelten digitalen Datenstroms einer zweiten internen Codierung mittels mindestens eines zweiten bestimmten Leistungscodes, um diese Gruppe von durch raum-zeitliche Kombinationen codierten elementaren digitalen Datenströmen zu erzeugen, durch Übertragung jedes in Symbole unterteilten elementaren digitalen Datenstroms mittels einer unterschiedlichen Sendeantenne gemäß einer Gruppe von auf einem Übertragungskanal übertragenen elementaren Datenströmen, wobei die Gruppe der Sendeantennen ein Netz von Sendeantennen mit Raum-Diversity bildet, wobei dieses Decodiersystem aufweist:

- mehrere Empfangsantennen ($ra_r$), die es ermöglichen, die Gruppe von auf diesem Übertragungskanal übertragenen elementaren digitalen Datenströmen zu empfangen, wobei die Empfangsantennen in einer Anzahl vorliegen, die unabhängig von der Anzahl $\nu$ von Sendeantennen ist und ein Netz von Empfangsantennen mit Raum-Diversity bilden, um eine Gruppe von empfangenen elementaren Modulationssymbolströmen zu definieren;
- Mittel zur Turbo-Detection der empfangenen elementaren Modulationssymbolströme durch iterative Egalisierung und damit verbundene Erfassung und Decodierung, wobei die Mittel zur Turbo-Detection aufweisen:

• Mittel (210) zur Egalisierung des Übertragungskanals und der verbundenen Decodierung mittels der zweiten internen Codierung ausgehend von einem extrinsischen Informationsstrom über die vom ersten externen Code codierten und verschachtelten Bits, der von einer Decodierung ausgehend vom externen Code stammt, wobei der extrinsische Informationsstrom über die vom ersten externen Code codierten und verschachtelten Bits eine A-priori-Information bildet, wobei die Mittel zur Egalisierung des Übertragungskanals und zur damit verbundenen Decodierung es ausgehend von den empfangenen elementaren Modulationssymbolströmen erlauben, einen ersten extrinsischen Informationsstrom über die vom ersten externen Code codierten und verschachtelten Bits zu erzeugen;
• Entschachtelungsmittel (211) des ersten extrinsischen Informationsstroms, um einen zweiten extrinsischen Informationsstrom über die codierten Bits zu erzeugen, die von den Mitteln zur Egalisierung und damit verbundenen Decodierung kommen;
• Mittel zur Decodierung (212) ausgehend vom ersten externen Code, die den zweiten extrinsischen Informationsstrom empfangen und es ermöglichen, einen dritten extrinsischen Informationsstrom über die codierten Bits zu erzeugen, der von der Decodierung ausgehend vom ersten externen Code stammt;
• Verschachtelungsmittel (213) des dritten extrinsischen Informationsstroms, um den extrinsischen Informationsstrom über die vom ersten externen Code codierten und verschachtelten Bits zu erzeugen, der die A-priori-Information bildet, die in die Mittel zur Egalisierung des Übertragungskanals und verbundenen Decodierung rückgespeist wird.

**11.** System nach Anspruch 10, **dadurch gekennzeichnet, dass** die Mittel zur Egalisierung und verbundenen Decodierungsmittel aufweisen:

- einen Modul (210a) zum Einspeisen der A-priori-Information, der Demultiplexiermittel aufweist, die die A-priori-Information empfangen, die aus dem extrinsischen Informationsstrom über die vom ersten externen Code codierten und verschachtelten Bits besteht, und eine Gruppe von A-priori-Informationsströmen über die Bits von Benutzerrahmen liefern, wobei die Gruppe von Informationsströmen auf die gleiche Anzahl $\nu$ von Demultiplexierkanälen demultiplexiert wird wie die Anzahl von elementaren codierten und verschachtelten Datenströmen, die beim Senden erzeugt werden;
- Decodiermittel (210b) mit gewichtetem Eingang und Ausgang, die am Eingang einerseits den A-priori-Informationsstrom über die Bits von Benutzerrahmen und andererseits die empfangenen elementaren Modulationssymbolströme empfangen, und einen Strom von auf die Bits der Benutzerrahmen gewichteten Ausgangssignalen liefern,

- mehrere Subtrahiermittel (210c), die es ermöglichen, von jedem Strom von auf die Bits der Benutzerrahmen gewichteten Ausgängen die A-priori-Information über die Bits von Benutzerrahmen abzuziehen, und einen extrinsischen Informationsstrom über die Bits der Benutzerrahmen liefern;

- Multiplexiermittel (210d) der extrinsischen Informationsströme, die es ausgehend vom extrinsischen Informationsstrom über die Bits der Benutzerrahmen ermöglichen, den ersten extrinsischen Informationsstrom über die vom ersten Code codierten und verschachtelten Bits zu liefern.

12. System nach Anspruch 10 oder 11, **dadurch gekennzeichnet, dass** die Mittel zum Decodieren ausgehend vom ersten externen Code aufweisen:

- einen Decodiermodul (212a) mit gewichtetem Eingang und Ausgang, der den zweiten extrinsischen Informationsstrom über die codierten Bits der vom Prozess der Egalisierung und damit verbundenen Decodierung empfängt und einen Strom von gewichteten Ausgangsdaten liefert, die für eine A-posteriori-Information über die codierten Bits repräsentativ sind;

- einen Subtrahiermodul (212b), der es ermöglicht, vom Strom von gewichteten Ausgangdaten, die für eine A-posteriori-Information über die codierten Bits repräsentativ sind, den zweiten extrinsischen Informationsstrom zu subtrahieren, und den dritten extrinsischen Informationsstrom über die codierten Bits liefert, der von der Decodierung ausgehend vom ersten externen Code stammt.

```
              ┌───────────┐
              │    IDS     │
              └─────┬──────┘
                    │          {d_1, ..., d_{τ0}}
                    ▼
     ┌──────────────────────────┐  A    d_n = {d_n, 1, ..., d_n,k_0}
     │   CODAGE EXTERNE          │
     │        C°                 │
     └────────────┬─────────────┘
                  │   C°DS      {c_1, ..., c_{τ0}}
                  ▼
     ┌──────────────────────────┐  B    c_n = {c_n, 1, ..., c_n,n_0}
     │  ENTRELACEMENT PAR BLOCS  │
     │          π                │
     └────────────┬─────────────┘
                  │   ILC°DS
                  ▼
     ┌──────────────────────────┐  C
     │     DEMUX                 │
     │          ν voies          │
     └────────────┬─────────────┘
                  │  {EILC°DS_m}_{m=1}^{m=ν}
                  ▼
     ┌──────────────────────────┐  D
     │   CODAGE INTERNE          │
     │       Ξ^m                 │
     └────────────┬─────────────┘
                  │  {EILC°Ξ^m DS_m}_{m=1}^{m=ν} = {EILCDS_m}_{m=1}^{m=ν}
                  ▼
     ┌──────────────────────────┐
     │ TRANSMISSION SUR ANTENNE  │  avec C = C° * Ξ^m
  E  │ DISTINCTE  {ta_m}_{m=1}^{m=ν}│  Ξ^m = C^2 ∀_m
     └────────────┬─────────────┘  ou
                  │                 Ξ^m ≠ Ξ^{m'} si m≠m'
                  ▼
              ┌──────────────────┐
              │{TEILCDS_m}_{m=1}^{m=ν}│
              └──────────────────┘
```

**FIG. 1a**

IDS

**A** — CODAGE EXTERNE C°

C°DS

**B** — ENTRELACEMENT PAR BLOCS

ILC°DS

**C** — DEMUX G voies

$\{EILC°DS_m\}_{m=1}^{m=\nu}$

**D** — CODAGE INTERNE $\Xi^m$

$\{EILC°\Xi^m DS_m\}_{m=1}^{m=\nu} = \{EILCDS_m\}_{m=1}^{m=\nu}$

**E** — TRANSMISSION SUR ANTENNE DISTINCTE PAR GROUPE $\{ta_{tm}\}_{t=1,\ m=1}^{\eta_m\quad \nu}$

avec $C = C° * \Xi^m$

$\Xi^m = C^2\ \forall_m$

ou

$\Xi^m \neq \Xi^{m'}$ si $m \neq m'$

$\{TEILCDS_{k,m}\}$

**FIG. 1b**

FIG. 2a

EP 1 362 447 B1

FIG. 2b

FIG. 2c

$\Xi^m = C^2 \ \forall_m$
ou
$\Xi^m \neq \Xi^{m'} \ \forall \ m \neq m'$
avec
$C = C^\circ \star \Xi^m$

**FIG. 3a**

$\{ta_{tm}\}_{t=1, \ m=1}^{\eta_m \ \ \nu}$

**FIG. 3b**

FIG. 4

**FIG. 5a**

**FIG. 5b**

**FIG. 5c**